# EUROPEAN PATENT APPLICATION

(11) **EP 4 425 734 A1**
(43) Date of publication of application: **04.09.2024**
(21) Application number: 21965284.9
(22) Date of filing: 29.11.2021
(51) Int. Cl.: H02J 3/36, H02M 3/155, H05K 7/20

(54) **POWER SUPPLY SYSTEM, POWER CONVERSION APPARATUS, AND POWER SYSTEM**

(71) Applicant: Huawei Digital Power Technologies Co., Ltd., Shenzhen, Guangdong 518043 (CN)
(72) Inventor: CHEN, Jun, Shenzhen, Guangdong 518043 (CN); HUI, Xiaowei, Shenzhen, Guangdong 518043 (CN); SUN, Faming, Shenzhen, Guangdong 518043 (CN)
(74) Representative: Gill Jennings & Every LLP
(86) International application number: PCT/CN2021/133989
(87) International publication number: WO 2023/092553

(57) **Abstract**

This application provides a power supply system, a power conversion device, and a power system. The power supply system may include a photovoltaic array and a power conversion device coupled to the photovoltaic array. The power conversion device includes a power cavity, a heat dissipation cavity, a power device, a magnetic element, at least one first heat sink, and at least one second heat sink. The power cavity and the heat dissipation cavity communicate with each other to form a first air duct, the power device is disposed in the power cavity, the at least one second heat sink is disposed in the heat dissipation cavity, first heat sinks may be connected to the power device, and the magnetic element is disposed in the first air duct. When the power conversion device works, the power device and the magnetic element generate heat. In this case, the first heat sinks may dissipate the heat generated by the power device, and second heat sinks may dissipate the heat generated by the magnetic element. In this application, the first heat sink and the second heat sink may be separately disposed to dissipate the heat for the power device and the magnetic element, and a heat dissipation capability is strong.

## Description

### TECHNICAL FIELD

This application relates to the field of power electronics technologies, and in particular, to a power supply system, a power conversion device, and a power system.

### BACKGROUND

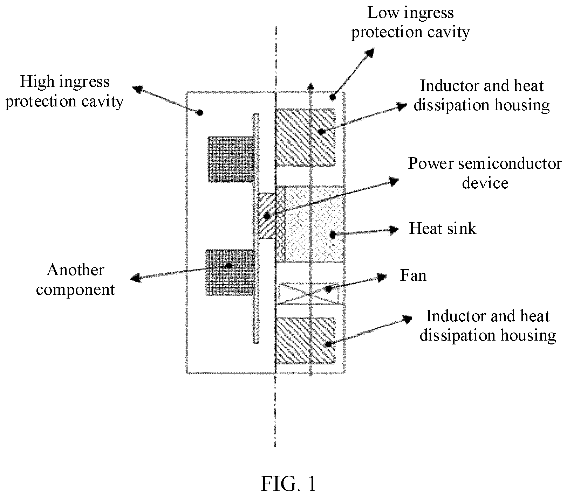

As a power density of a power converter (such as a combiner box or an inverter) continuously increases, heat consumption of electronic components in the power converter also increases sharply. Therefore, how to resolve a heat dissipation problem of the power converter is particularly important. Currently, the power converter may use a cavity splitting design. As shown in FIG. 1, a power converter may include a high ingress protection cavity and a low ingress protection cavity. The high ingress protection cavity is a closed cavity, and the low ingress protection cavity is a direct ventilation cavity. The power converter further includes a power semiconductor device, an inductor, a heat dissipation housing, a heat sink, a fan, another component, and the like. The components are disposed in the high ingress protection cavity and the low ingress protection cavity and may dissipate heat by using the heat sink and the heat dissipation housing, thereby resolving a heat dissipation problem of the power converter. However, when heat consumption in the high ingress protection cavity is increasingly large, due to a limited heat dissipation area and heat dissipation capability of the high ingress protection cavity, service life and reliability risks of the components in the cavity are high, and the heat dissipation capability is poor.

### SUMMARY

This application provides a power supply system, a power conversion device, and a power system. A first heat sink and a second heat sink may be separately disposed to dissipate heat for a power device and a magnetic element, thereby improving natural heat dissipation capabilities of a power cavity and a heat dissipation cavity. The heat dissipation capability is strong, and applicability is high.

According to a first aspect, this application provides a power supply system. The power supply system includes a photovoltaic array and a power conversion device coupled (for example, directly connected or indirectly connected by using another component) to the photovoltaic array, and the power conversion device may include a power cavity, a heat dissipation cavity, a power device, a magnetic element, at least one first heat sink, and at least one second heat sink. The power device herein may be understood as a high-power electronic component used for electric energy conversion, circuit control, and the like in the power conversion device. The magnetic element may be understood as an electronic component used for energy storage, energy conversion, and electrical isolation in the power conversion device. The power cavity and the heat dissipation cavity communicate with each other to form a first air duct (for example, a passage that is for air circulation and that is made of materials such as concrete and brick). The power device is disposed in the power cavity, the at least one second heat sink is disposed in the heat dissipation cavity, first heat sinks may be connected to the power device, and the magnetic element may be disposed in the first air duct. That the power cavity and the heat dissipation cavity communicate with each other may be understood as that air in the power cavity may flow to the heat dissipation cavity, and air in the heat dissipation cavity may flow to the power cavity. When the power conversion device works, the power device and the magnetic element generate heat. In this case, the first heat sinks may dissipate the heat generated by the power device, and second heat sinks may be configured to dissipate the heat generated by the magnetic element, so that the power device and the magnetic element work within an allowable temperature range (that is, heat dissipation is implemented). The allowable temperature range herein may be determined by parameters configured for the power device and the magnetic element, or the allowable temperature range may be understood as a temperature range set by a user for the power device and the magnetic element.

In this application, because heat consumption and temperature specifications of the power device and the magnetic element are greatly different, the first heat sink and the second heat sink may be separately disposed to dissipate the heat for the power device and the magnetic element, thereby greatly improving a heat dissipation capability. In addition, because the power cavity and the heat dissipation cavity communicate with each other, air may circulate and flow in the two cavities, thereby improving natural heat dissipation capabilities of the power cavity and the heat dissipation cavity, and further reducing temperatures in the two cavities to prolong service lives and improve reliability of devices in the cavities. The heat dissipation capability is stronger, and applicability is high.

With reference to the first aspect, in a first possible implementation, the power conversion device further includes at least one condenser, and a condenser is connected to at least one of the first heat sinks and/or at least one of the second heat sinks by using a steam pipe and a liquid pipe. In other words, a condenser may be connected to at least one first heat sink by using the steam pipe and the liquid pipe, a condenser may be connected to at least one second heat sink by using the steam pipe and the liquid pipe, or a condenser may be connected to at least one first heat sink and at least one second heat sink by using the steam pipe and the liquid pipe. In other words, the first heat sink and the second heat sink may share a condenser, or the first heat sink and the second heat sink each use a condenser. The condenser may be configured to: condense first gas and/or second gas by using the steam pipe, and enable liquid generated after the condensation to flow back, through the liquid pipe, to the first heat sink and/or the second heat sink, thereby implementing a two-phase circulation process of gas and liquid between the first heat sink and/or the second heat sink and the condenser, and further implementing the heat dissipation for the power device and the magnetic element. The first gas may be gas generated by the first heat sink in a heat dissipation process, and the second gas may be gas generated by the second heat sink in a heat dissipation process. In the power supply system provided in this application, the gas generated by the heat sink (that is, the first heat sink and the second heat sink) may be condensed and refluxed by using the condenser, so that heat generated by the power device and the magnetic element is dissipated by using the efficient two-phase circulation process of gas and liquid. In this way, heat dissipation costs can be greatly reduced, a heat dissipation volume of the power conversion device can be reduced, a heat dissipation capability is stronger, output power of the power conversion device can be further improved, and applicability is higher.

With reference to the first aspect or the first possible implementation of the first aspect, in a second possible implementation, the magnetic element may be disposed in the power cavity or the heat dissipation cavity.

With reference to the first aspect or the first possible implementation of the first aspect, in a third possible implementation, one part of the magnetic element may be disposed in the power cavity, and the other part of the magnetic element may be disposed in the heat dissipation cavity.

With reference to any one of the first aspect to the third possible implementation of the first aspect, in a fourth possible implementation, the at least one first heat sink may be disposed in the power cavity, and may be configured to rapidly dissipate heat for the power device and another component in the power cavity, thereby further improving a heat dissipation capability.

With reference to any one of the first aspect to the third possible implementation of the first aspect, in a fifth possible implementation, the power conversion device may further include a housing, the power cavity, the heat dissipation cavity, and the at least one first heat sink may be disposed in the housing, and the at least one first heat sink may be disposed outside the power cavity and the heat dissipation cavity. This does not occupy internal space of the power cavity, thereby reducing a volume of the power cavity.

With reference to any one of the first aspect to the third possible implementation of the first aspect, in a sixth possible implementation, the at least one heat sink may be embedded in a side that is of the power cavity and that faces the heat dissipation cavity, so that heat dissipation can be rapidly performed on the power device without occupying internal space of the power cavity, and applicability is higher.

With reference to any one of the first aspect to the sixth possible implementation of the first aspect, in a seventh possible implementation, the power conversion device may further include at least one first fan disposed in the heat dissipation cavity. The first fan may be understood as an internal circulation fan configured to implement airflow circulation in the power cavity and the heat dissipation cavity. The first fan may be configured to push airflow, so that the heat generated by the magnetic element passes through the second heat sinks, and further, the second heat sinks can dissipate the heat for the magnetic element. Optionally, the power conversion device further includes another component disposed in the power cavity in addition to the power device. In this case, the first fan may push the airflow, so that heat (namely, heat consumption) generated by the another component passes through the second heat sinks, and further, the second heat sinks can dissipate the heat for the another component. In the power supply system provided in this application, the airflow circulation in the power cavity and the heat dissipation cavity may be implemented through flow mixing of the first fan, so that the heat generated by the magnetic element passes through the second heat sinks, thereby rapidly dissipating heat for the magnetic element. Heat dissipation effect is better, and applicability is higher.

With reference to the seventh possible implementation of the first aspect, in an eighth possible implementation, the first fan is further configured to dissipate the heat generated by the magnetic element and heat generated by the second heat sinks, so that the heat generated by the magnetic element may be dissipated simultaneously by using the second heat sinks and the first fan, and a heat dissipation capability and heat dissipation efficiency are further improved. In addition, the second heat sinks also generate the heat in a heat dissipation process. In this case, the heat generated by the second heat sinks may be dissipated by using the first fan, thereby prolonging a service life and improving reliability of the second heat sink, improving a heat dissipation capability of the entire power conversion device, and enhancing applicability.

With reference to the seventh possible implementation of the first aspect or the eighth possible implementation of the first aspect, in a ninth possible implementation, the heat dissipation cavity may include but is not limited to a C-shaped cavity. When the heat dissipation cavity is the C-shaped cavity, the first fan may be separately disposed at a first communication end and a second communication end between the C-shaped cavity and the power cavity, and the magnetic element may be disposed in the power cavity. The first communication end and the second communication end herein may be understood as two ends at which the C-shaped cavity is in contact with the power cavity. In the power supply system provided in this application, the first fan may be separately disposed at the first communication end and the second communication end, to enhance airflow circulation (that is, internal circulation flow) in the power cavity and the heat dissipation cavity, and a heat dissipation capability is stronger.

With reference to the seventh possible implementation of the first aspect or the eighth possible implementation of the first aspect, in a tenth possible implementation, when the heat dissipation cavity is a C-shaped cavity, the first fan may be disposed at a first communication end between the C-shaped cavity and the power cavity, and the magnetic element may be disposed at a second communication end between the C-shaped cavity and the power cavity. It is assumed that a first fan is disposed in the C-shaped cavity, heat dissipation costs can be reduced while the first fan and the second heat sinks can dissipate the heat for the magnetic element, and applicability is higher.

With reference to any one of the seventh possible implementation of the first aspect to the tenth possible implementation of the first aspect, in an eleventh possible implementation, the power conversion device may further include an airflow distribution component and other devices (for example, a board and a resistor-capacitor element disposed on the board) disposed in the power cavity. The airflow distribution component may be connected to the first air duct (or the airflow distribution component is disposed in the first air duct). The airflow distribution component herein may be understood as a component that is in the power conversion device and that is configured to perform directional airflow distribution. The resistor-capacitor element may be understood as an electronic device that is in the power conversion device and that is configured to block electron flow or store an electron. The resistor-capacitor element may include but is not limited to a resistor and a capacitor. The airflow distribution component may be configured to distribute, through the first air duct, airflow generated by first fans to the board and the resistor-capacitor element, thereby dissipating heat for the board and the resistor-capacitor element. Heat dissipation effect is better and a heat dissipation capability is stronger. Optionally, when the power conversion device includes at least one first fan, the first fan and the second heat sink can rapidly dissipate heat for the board and the resistor-capacitor element, and a heat dissipation capability is strong.

With reference to the eleventh possible implementation of the first aspect, in a twelfth possible implementation, the airflow distribution component may be disposed in the power cavity, thereby distributing the airflow generated by the first fans to the board and the resistor-capacitor element in a directional manner.

With reference to the eleventh possible implementation of the first aspect, in a thirteenth possible implementation, when the heat dissipation cavity is the C-shaped cavity, the airflow distribution component may be disposed at one end of the C-shaped cavity, and the airflow distribution component is inserted into the power cavity, thereby distributing the airflow generated by the first fans to the board and the resistor-capacitor element in a directional manner.

With reference to any one of the first aspect to the thirteenth possible implementation of the first aspect, in a fourteenth possible implementation, the power conversion device further includes a second fan and the at least one condenser (which may be disposed in the housing), and the condenser is connected to the at least one of the first heat sinks and/or the at least one of the second heat sinks by using the steam pipe and the liquid pipe. The second fan may be disposed outside the power cavity and the heat dissipation cavity. The second fan may be understood as an external circulation fan configured to implement airflow circulation outside the power cavity and the heat dissipation cavity. The second fan may be configured to dissipate heat generated by condensers and heat generated by the first heat sinks. Therefore, a flow rate of airflow passing through the condensers and the first heat sinks is increased, heat dissipation effect is enhanced, and a heat dissipation capability is stronger.

With reference to the fourteenth possible implementation of the first aspect, in a fifteenth possible implementation, the second fan may be connected to the condensers through a second air duct. The second air duct herein may be understood as an air duct of each of the condensers. The second fan may be configured to dissipate, through the second air duct, the heat generated by the condensers, thereby further enhancing heat dissipation effect.

With reference to any one of the first aspect to the fifteenth possible implementation of the first aspect, in a sixteenth possible implementation, the power cavity and the heat dissipation cavity are waterproof and dustproof to form a high ingress protection cavity. Ingress protection ratings of the power cavity and the heat dissipation cavity may be greater than or equal to an ingress protection rating threshold (for example, ingress protection (ingress protection, IP)67), so that damage to the power device and the magnetic element can be avoided, and service lives of the power device and the magnetic element are prolonged.

With reference to any one of the first aspect to the sixteenth possible implementation of the first aspect, in a seventeenth possible implementation, because the power cavity and the heat dissipation cavity communicate with each other, when a breather valve is disposed in the power cavity or the heat dissipation cavity, the breather valve can balance atmospheric pressure in the power cavity and the heat dissipation cavity with atmospheric pressure outside the cavities, thereby ensuring air circulation inside and outside the cavities, and further improving natural heat dissipation capabilities of the power cavity and the heat dissipation cavity.

With reference to any one of the first aspect to the seventeenth possible implementation of the first aspect, in an eighteenth possible implementation, the power conversion device may include but is not limited to a photovoltaic inverter, a direct current combiner box, an alternating current combiner box, and/or a direct current (direct current, DC)-to-DC converter. Electronic devices in the photovoltaic inverter, the direct current combiner box, the alternating current combiner box, and/or the DC-to-DC converter herein may include but are not limited to the power device, the magnetic element, and another device in the power conversion device. Because the power conversion device used in the power supply system has a strong heat dissipation capability and low heat dissipation costs, power supply efficiency and power supply reliability of the power supply system can be improved, costs are lower, and applicability is higher.

With reference to any one of the first aspect to the eighteenth possible implementation of the first aspect, in a nineteenth possible implementation, in a photovoltaic power supply application scenario, the power conversion device includes the direct current combiner box and the photovoltaic inverter connected to the direct current combiner box, the power supply system further includes a box-type transformer station (which may be referred to as a box-type transformer station for short), the photovoltaic inverter may be connected to an input end of the box-type transformer station, and an output end of the box-type transformer station may be connected to an alternating current grid, so that a direct current voltage provided by the photovoltaic array can be used to supply power to the alternating current grid. Because the direct current combiner box and the photovoltaic inverter used in the power supply system have strong heat dissipation capabilities and low heat dissipation costs, power supply efficiency and power supply reliability of the power supply system can be improved, costs are lower, and applicability is higher.

With reference to any one of the first aspect to the eighteenth possible implementation of the first aspect, in a twentieth possible implementation, in a photovoltaic power supply application scenario, the power conversion device includes the photovoltaic inverter and the alternating current combiner box connected to the photovoltaic inverter, the power supply system further includes a box-type transformer station, the alternating current combiner box is connected to an input end of the box-type transformer station, and an output end of the box-type transformer station is connected to an alternating current grid, so that a direct current voltage provided by the photovoltaic array can be used to supply power to the alternating current grid. Because the photovoltaic inverter and the alternating current combiner box used in the power supply system have strong heat dissipation capabilities and low heat dissipation costs, power supply efficiency and power supply reliability of the power supply system can be improved, costs are lower, and applicability is higher.

With reference to any one of the first aspect to the eighteenth possible implementation of the first aspect, in a twenty-first possible implementation, in a photovoltaic power supply application scenario, the power conversion device may be the photovoltaic inverter, the power supply system further includes the direct current combiner box and a box-type transformer station, the photovoltaic array may be connected to the photovoltaic inverter through the direct current combiner box, the photovoltaic inverter may be connected to an input end of the box-type transformer station, and an output end of the box-type transformer station may be connected to an alternating current grid, so that a direct current voltage provided by the photovoltaic array can be used to supply power to the alternating current grid. Because the photovoltaic inverter used in the power supply system has a strong heat dissipation capability and low heat dissipation costs, power supply efficiency and power supply reliability of the power supply system can be improved, costs are lower, and applicability is higher.

With reference to any one of the first aspect to the eighteenth possible implementation of the first aspect, in a twenty-second possible implementation, in a photovoltaic power supply application scenario, the power conversion device may be the photovoltaic inverter, the power supply system further includes the alternating current combiner box and a box-type transformer station, the photovoltaic array may be connected to the alternating current combiner box through the photovoltaic inverter, the alternating current combiner box may be connected to an input end of the box-type transformer station, and an output end of the box-type transformer station may be connected to an alternating current grid, so that a direct current voltage provided by the photovoltaic array can be used to supply power to the alternating current grid. Because the photovoltaic inverter used in the power supply system has a strong heat dissipation capability and low heat dissipation costs, power supply efficiency and power supply reliability of the power supply system can be improved, costs are lower, and applicability is higher.

With reference to any one of the first aspect to the eighteenth possible implementation of the first aspect, in a twenty-third possible implementation, in a photovoltaic power supply application scenario, the power conversion device may be the direct current combiner box, the power supply system further includes the photovoltaic inverter and a box-type transformer station, the photovoltaic array may be connected to the photovoltaic inverter through the direct current combiner box, the photovoltaic inverter may be connected to an input end of the box-type transformer station, and an output end of the box-type transformer station may be connected to an alternating current grid, so that a direct current voltage provided by the photovoltaic array can be used to supply power to the alternating current grid. Because the direct current combiner box used in the power supply system has a strong heat dissipation capability and low heat dissipation costs, power supply efficiency and power supply reliability of the power supply system can be improved, costs are lower, and applicability is higher.

With reference to any one of the first aspect to the eighteenth possible implementation of the first aspect, in a twenty-fourth possible implementation, in a photovoltaic power supply application scenario, the power conversion device may be the alternating current combiner box, the power supply system further includes the photovoltaic inverter and a box-type transformer station, the photovoltaic array may be connected to the alternating current combiner box through the photovoltaic inverter, the alternating current combiner box may be connected to an input end of the box-type transformer station, and an output end of the box-type transformer station may be connected to an alternating current grid, so that a direct current voltage provided by the photovoltaic array can be used to supply power to the alternating current grid. Because the alternating current combiner box used in the power supply system has a strong heat dissipation capability and low heat dissipation costs, power supply efficiency and power supply reliability of the power supply system can be improved, costs are lower, and applicability is higher.

With reference to any one of the first aspect to the eighteenth possible implementation of the first aspect, in a twenty-fifth possible implementation, in a photovoltaic power supply application scenario, the power conversion device may be the DC-to-DC converter, the power supply system further includes a direct current bus and a DC-to-alternating current (alternating current, which may be referred to as AC for short) converter, the DC-to-DC converter may be connected to an input end of the DC-to-AC converter through the direct current bus, and an output end of the DC-to-AC converter may be connected to an alternating current grid or an alternating current load, so that a direct current voltage provided by the photovoltaic array can be used to supply power to the alternating current grid or the alternating current load. Because the DC-to-DC converter used in the power supply system has a strong heat dissipation capability and low heat dissipation costs, power supply efficiency and power supply reliability of the power supply system can be improved, costs are lower, and applicability is higher.

With reference to the twenty-fifth possible implementation of the first aspect, in a twenty-sixth possible implementation, in a solar energy storage hybrid power supply application scenario, the power supply system further includes an energy storage module and a DC-to-DC conversion module connected to the energy storage module, and the DC-to-DC conversion module may be connected to the input end of the DC-to-AC converter through the direct current bus, so that a direct current voltage provided by the photovoltaic array and a direct current voltage provided by the energy storage module can be used to supply power to an alternating current grid or an alternating current load, thereby improving system power supply efficiency and power supply flexibility, and enhancing applicability.

With reference to the twenty-fifth possible implementation of the first aspect or the twenty-sixth possible implementation of the first aspect, in a twenty-seventh possible implementation, in a solar-wind hybrid power supply application scenario, a wind energy storage hybrid power supply application scenario, or a solar wind energy storage hybrid power supply application scenario, the power supply system further includes a generator and an alternating current AC-to-DC conversion module connected to the generator, and the AC-to-DC conversion module may be connected to the input end of the DC-to-AC converter through the direct current bus, so that a direct current voltage provided by the photovoltaic array, a direct current voltage provided by the energy storage module, and/or an alternating current voltage provided by the generator may be used to supply power to an alternating current grid or an alternating current load, thereby improving system power supply efficiency and power supply flexibility, and enhancing applicability.

According to a second aspect, this application provides a power conversion device. The power conversion device includes a power cavity, a heat dissipation cavity, a power device, a magnetic element, at least one first heat sink, and at least one second heat sink, the power cavity and the heat dissipation cavity may communicate with each other to form a first air duct, the power device is disposed in the power cavity, the at least one second heat sink is disposed in the heat dissipation cavity, first heat sinks in the at least one first heat sink may be connected to the power device, and the magnetic element may be disposed in the first air duct. When the power conversion device works, the power device and the magnetic element generate heat. In this case, the first heat sinks may be configured to dissipate the heat generated by the power device, and second heat sinks may be configured to dissipate the heat generated by the magnetic element, so that the power device and the magnetic element work within an allowable temperature range (that is, heat dissipation is implemented). In this application, because heat consumption and temperature specifications of the power device and the magnetic element are greatly different, the first heat sink and the second heat sink may be separately disposed to dissipate the heat for the power device and the magnetic element, thereby greatly improving a heat dissipation capability. In addition, because the power cavity and the heat dissipation cavity communicate with each other, air may circulate and flow in the two cavities, thereby improving natural heat dissipation capabilities of the power cavity and the heat dissipation cavity, and further reducing temperatures in the two cavities to prolong service lives and improve reliability of devices in the cavities. The heat dissipation capability is stronger, and applicability is high.

With reference to the second aspect, in a first possible implementation, the power conversion device further includes at least one condenser, and a condenser is connected to at least one of the first heat sinks and/or at least one of the second heat sinks by using a steam pipe and a liquid pipe. In other words, a condenser may be connected to at least one first heat sink by using the steam pipe and the liquid pipe, a condenser may be connected to at least one second heat sink by using the steam pipe and the liquid pipe, or a condenser may be connected to at least one first heat sink and at least one second heat sink by using the steam pipe and the liquid pipe. In other words, the first heat sink and the second heat sink may share a condenser, or the first heat sink and the second heat sink each use a condenser. The condenser may be configured to: condense first gas and/or second gas by using the steam pipe, and enable liquid generated after the condensation to flow back, through the liquid pipe, to the first heat sink and/or the second heat sink, thereby implementing a two-phase circulation process of gas and liquid between the first heat sink and/or the second heat sink and the condenser, and further implementing the heat dissipation for the power device and the magnetic element. The first gas may be gas generated by the first heat sink in a heat dissipation process, and the second gas may be gas generated by the second heat sink in a heat dissipation process. In the power conversion device provided in this application, the gas generated by the heat sink (that is, the first heat sink and the second heat sink) may be condensed and refluxed by using the condenser, so that heat generated by the power device and the magnetic element is dissipated by using the efficient two-phase circulation process of gas and liquid. In this way, heat dissipation costs can be greatly reduced, a heat dissipation volume of the power conversion device can be reduced, a heat dissipation capability is stronger, output power of the power conversion device can be further improved, and applicability is higher.

With reference to the second aspect or the first possible implementation of the second aspect, in a second possible implementation, the magnetic element may be disposed in the power cavity or the heat dissipation cavity.

With reference to the second aspect or the first possible implementation of the second aspect, in a third possible implementation, one part of the magnetic element may be disposed in the power cavity, and the other part of the magnetic element may be disposed in the heat dissipation cavity.

With reference to any one of the second aspect to the third possible implementation of the second aspect, in a fourth possible implementation, the at least one first heat sink may be disposed in the power cavity, and may be configured to rapidly dissipate heat for the power device and another device in the power cavity, thereby further improving a heat dissipation capability.

With reference to any one of the second aspect to the third possible implementation of the second aspect, in a fifth possible implementation, the power conversion device may further include a housing, the power cavity, the heat dissipation cavity, and the at least one first heat sink may be disposed in the housing, and the at least one first heat sink may be disposed outside the power cavity and the heat dissipation cavity. This does not occupy internal space of the power cavity, thereby reducing a volume of the power cavity.

With reference to any one of the second aspect to the third possible implementation of the second aspect, in a sixth possible implementation, the at least one heat sink may be embedded in a side that is of the power cavity and that faces the heat dissipation cavity, so that heat dissipation can be rapidly performed on the power device without occupying internal space of the power cavity, and applicability is higher.

With reference to any one of the second aspect to the sixth possible implementation of the second aspect, in a seventh possible implementation, the power conversion device further includes at least one first fan disposed in the heat dissipation cavity, and the first fan may be configured to push airflow, so that the heat generated by the magnetic element passes through the second heat sinks, and further, the second heat sinks can dissipate the heat for the magnetic element. Optionally, the power conversion device further includes another component disposed in the power cavity in addition to the power device. In this case, the first fan may push the airflow, so that heat (namely, heat consumption) generated by the another component passes through the second heat sinks, and further, the second heat sinks can dissipate the heat for the another component. In the power conversion device provided in this application, airflow circulation in the power cavity and the heat dissipation cavity may be implemented through flow mixing of the first fan, so that the heat generated by the magnetic element passes through the second heat sinks, thereby rapidly dissipating the heat for the magnetic element. Heat dissipation effect is better, and applicability is higher.

With reference to the seventh possible implementation of the second aspect, in an eighth possible implementation, the first fan is further configured to dissipate the heat generated by the magnetic element and heat generated by the second heat sinks, so that the heat generated by the magnetic element may be dissipated simultaneously by using the second heat sinks and the first fan, and a heat dissipation capability and heat dissipation efficiency are further improved. In addition, the second heat sinks also generate the heat in a heat dissipation process. In this case, the heat generated by the second heat sinks may be dissipated by using the first fan, thereby prolonging a service life and improving reliability of the second heat sink, improving a heat dissipation capability of the entire power conversion device, and enhancing applicability.

With reference to the seventh possible implementation of the second aspect or the eighth possible implementation of the second aspect, in a ninth possible implementation, the heat dissipation cavity may include but is not limited to a C-shaped cavity. When the heat dissipation cavity is the C-shaped cavity, the first fan may be separately disposed at a first communication end and a second communication end between the C-shaped cavity and the power cavity, and the magnetic element may be disposed in the power cavity. In the power conversion device provided in this application, the first fan may be separately disposed at the first communication end and the second communication end, to enhance airflow circulation (that is, internal circulation flow) in the power cavity and the heat dissipation cavity, and a heat dissipation capability is stronger.

With reference to the seventh possible implementation of the second aspect or the eighth possible implementation of the second aspect, in a tenth possible implementation, when the heat dissipation cavity is a C-shaped cavity, the first fan may be disposed at a first communication end between the C-shaped cavity and the power cavity, and the magnetic element may be disposed at a second communication end between the C-shaped cavity and the power cavity. It is assumed that a first fan is disposed in the C-shaped cavity, heat dissipation costs can be reduced while the first fan and the second heat sinks can dissipate the heat for the magnetic element, and applicability is higher.

With reference to any one of the seventh possible implementation of the second aspect to the tenth possible implementation of the second aspect, in an eleventh possible implementation, the power conversion device may further include an airflow distribution component and other devices (for example, a board and a resistor-capacitor element disposed on the board) disposed in the power cavity. The airflow distribution component may be connected to the first air duct (or the airflow distribution component is disposed in the first air duct). The airflow distribution component may be configured to distribute, through the first air duct, airflow generated by first fans to the board and the resistor-capacitor element, thereby dissipating heat for the board and the resistor-capacitor element. Heat dissipation effect is better, and a heat dissipation capability is stronger. Optionally, when the power conversion device includes at least one first fan, the first fan and the second heat sink can rapidly dissipate heat for the board and the resistor-capacitor element, and a heat dissipation capability is strong.

With reference to the eleventh possible implementation of the second aspect, in a twelfth possible implementation, the airflow distribution component may be disposed in the power cavity, thereby distributing the airflow generated by the first fans to the board and the resistor-capacitor element in a directional manner.

With reference to the eleventh possible implementation of the second aspect, in a thirteenth possible implementation, when the heat dissipation cavity is the C-shaped cavity, the airflow distribution component may be disposed at one end of the C-shaped cavity, and the airflow distribution component is inserted into the power cavity, thereby distributing the airflow generated by the first fans to the board and the resistor-capacitor element in a directional manner.

With reference to any one of the second aspect to the thirteenth possible implementation of the second aspect, in a fourteenth possible implementation, the power conversion device further includes a housing, and a second fan and the at least one condenser that are disposed in the housing, and the condenser is connected to the at least one of the first heat sinks and/or the at least one of the second heat sinks by using the steam pipe and the liquid pipe. The second fan may be disposed outside the power cavity and the heat dissipation cavity, may be configured to dissipate heat generated by condensers and heat generated by the first heat sinks. Therefore, a flow rate of airflow passing through the condensers and the first heat sinks is increased, heat dissipation effect is enhanced, and a heat dissipation capability is stronger.

With reference to the fourteenth possible implementation of the second aspect, in a fifteenth possible implementation, the second fan may be connected to the condensers through a second air duct. The second air duct herein may be understood as an air duct of each of the condensers. The second fan may be configured to rapidly dissipate, through the second air duct, the heat generated by the condensers, thereby further enhancing heat dissipation effect.

With reference to any one of the second aspect to the fifteenth possible implementation of the second aspect, in a sixteenth possible implementation, the power cavity and the heat dissipation cavity are waterproof and dustproof to form a high ingress protection cavity. Ingress protection ratings of the power cavity and the heat dissipation cavity may be greater than or equal to an ingress protection rating threshold (for example, IP67), so that damage to the power device and the magnetic element can be avoided, and service lives of the power device and the magnetic element are prolonged.

With reference to any one of the second aspect to the sixteenth possible implementation of the second aspect, in a seventeenth possible implementation, because the power cavity and the heat dissipation cavity communicate with each other, when a breather valve is disposed in the power cavity or the heat dissipation cavity, the breather valve can balance atmospheric pressure in the power cavity and the heat dissipation cavity with atmospheric pressure outside the cavities, thereby ensuring air circulation inside and outside the cavities, and further improving natural heat dissipation capabilities of the power cavity and the heat dissipation cavity.

According to a third aspect, this application provides a power system. The power system includes a power battery and the power conversion device connected to the power battery according to any one of the second aspect to the seventeenth possible implementation of the second aspect. The power system may be applicable to an electric device. The electric device may include, but is not limited to, an electric vehicle, electric amusement equipment, an electric train, an electric bicycle, a golf cart, ventilation equipment, stamping equipment, crystal equipment, a water pump, various machine tools, and another electric device. In this application, a power conversion device with a strong heat dissipation capability and low heat dissipation costs may be used, thereby prolonging a service life and improving reliability of the power conversion device, improving work efficiency of the power system, and enhancing applicability.

In this application, because the heat consumption and the temperature specifications of the power device and the magnetic element are greatly different, the first heat sink and the second heat sink may be separately disposed to dissipate the heat for the power device and the magnetic element, thereby greatly improving the heat dissipation capability. In addition, because the power cavity and the heat dissipation cavity communicate with each other, the air may circulate and flow in the two cavities, thereby improving the natural heat dissipation capabilities of the power cavity and the heat dissipation cavity, and further reducing the temperatures in the two cavities to prolong the service lives and improve the reliability of devices in the cavities. The heat dissipation capability is stronger, and the applicability is high.

### BRIEF DESCRIPTION OF DRAWINGS

FIG. 1 is a schematic diagram of a heat dissipation structure of a power converter;
FIG. 2 is a schematic diagram of an application scenario of a power conversion device according to this application;
FIG. 3 is a schematic diagram of a structure of a power conversion device according to this application;
FIG. 4 is a schematic diagram of another structure of a power conversion device according to this application;
FIG. 5 is a schematic diagram of another structure of a power conversion device according to this application;
FIG. 6 is a schematic diagram of another structure of a power conversion device according to this application;
FIG. 7 is a schematic diagram of another structure of a power conversion device according to this application;
FIG. 8 is a schematic diagram of another structure of a power conversion device according to this application;
FIG. 9 is a schematic diagram of another structure of a power conversion device according to this application;
FIG. 10 is a schematic diagram of another structure of a power conversion device according to this application;
FIG. 11 is a schematic diagram of another structure of a power conversion device according to this application;
FIG. 12 is a schematic diagram of still another structure of a power conversion device according to this application;
FIG. 13 is a schematic diagram of a structure of a power supply system according to this application;
FIG. 14 is a schematic diagram of another structure of a power supply system according to this application;
FIG. 15 is a schematic diagram of another structure of a power supply system according to this application;
FIG. 16 is a schematic diagram of another structure of a power supply system according to this application;
FIG. 17 is a schematic diagram of another structure of a power supply system according to this application;
FIG. 18 is a schematic diagram of still another structure of a power supply system according to this application; and
FIG. 19 is a schematic diagram of a structure of a power system according to this application.

### DESCRIPTION OF EMBODIMENTS

A power conversion device provided in this application is applicable to a plurality of application fields such as the new energy smart micro grid field, the power transmission and distribution field or the new energy field (for example, the photovoltaic grid-connected field or the wind grid-connected field), the photovoltaic power generation field (for example, supplying power to household equipment (such as a refrigerator and an air conditioner) or a grid), the wind power generation field, the high-power converter field (for example, converting a direct current voltage into a high-power high-voltage alternating current), or the electric device field (for example, a plurality of electric devices). This may be specifically determined based on an actual application scenario, and is not limited herein. The power conversion device provided in this application may be adapted to different application scenarios, for example, a photovoltaic power supply application scenario, a wind grid-connected power supply scenario, an electric vehicle charging scenario, or another application scenario. The following uses the photovoltaic power supply application scenario as an example for description, and details are not described below.

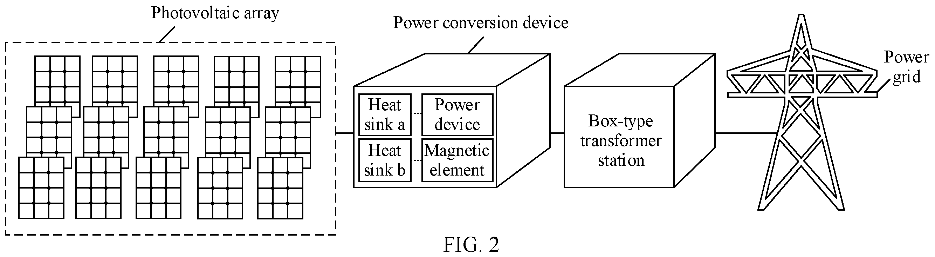

FIG. 2 is a schematic diagram of an application scenario of a power conversion device according to this application. As shown in FIG. 2, a power supply system includes a photovoltaic array, a power conversion device, and a box-type transformer station. The photovoltaic array may be connected to an input end of the box-type transformer station by using the power conversion device, and an output end of the box-type transformer may be connected to a grid. The photovoltaic array herein may include a plurality of photovoltaic strings connected in series and parallel, and one photovoltaic string may include a plurality of photovoltaic modules (which may also be referred to as solar cell panels or photovoltaic panels). In a process in which the power supply system supplies power to the grid, the power conversion device may output, based on a direct current voltage provided by the photovoltaic array, an alternating current voltage to the box-type transformer station. In this case, the box-type transformer station may supply power to the grid based on the alternating current voltage input by the power conversion device. In the process of supplying power to the grid, the power conversion device keeps working, so that electronic components inside the power conversion device continuously generate heat, and even the electronic components are damaged due to excessive heat and the power conversion device cannot work normally. Therefore, it is particularly important to perform rapid heat dissipation for the electronic components in the power conversion device. As shown in FIG. 2, the power conversion device includes a power device, a magnetic element, a heat sink a, and a heat sink b. The heat sink a may dissipate heat generated by the power device when the power conversion device works, and the heat sink b may dissipate heat generated by the magnetic element when the power conversion device works. Therefore, the heat sink a and the heat sink b may be separately disposed to rapidly dissipate heat for the power device and the magnetic element, thereby greatly improving a heat dissipation capability of the power conversion device, avoiding damage to the electronic components (that is, the power device and the magnetic element), further improving system power supply efficiency, and enhancing applicability.

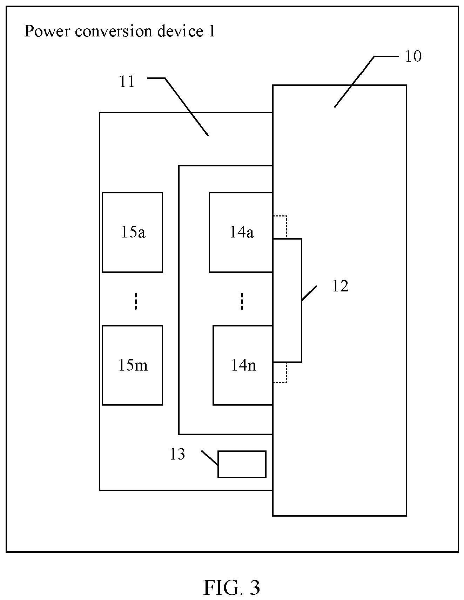

The following describes, by using examples with reference to FIG. 3 to FIG. 19, a power conversion device, a power supply system, a power system, and working principles of the power conversion device, the power supply system, and the power system provided in this application.

FIG. 3 is a schematic diagram of a structure of a power conversion device according to this application. A side view of the power conversion device provided in this application may be shown in FIG. 3. A power conversion device 1 includes a power cavity 10, a heat dissipation cavity 11, a power device 12, a magnetic element 13, and at least one first heat sink (that is, one or more first heat sinks, such as a first heat sink 14a to a first heat sink 14n), and at least one second heat sink (that is, one or more second heat sinks, such as a second heat sink 15a to a second heat sink 15m). The heat dissipation cavity 11 may include but is not limited to a C-shaped cavity. In this application, high-power electronic components that are in the power conversion device 1 and that are used in aspects such as electric energy conversion and circuit control may be collectively referred to as the power device 12. The power device 12 may include but is not limited to an insulated gate bipolar transistor (insulated gate bipolar transistor, IGBT) module. The IGBT module is a modular semiconductor product packaged by an IGBT chip and a free-wheeling diode chip bridged by using a specific circuit. In this application, electronic components that are in the power conversion device 1 and that are used for energy storage, energy conversion, and electrical isolation may be collectively referred to as the magnetic element 13. The magnetic element 13 may include but is not limited to a transformer and an inductor (which may be referred to as an inductor for short). The power cavity 10 and the heat dissipation cavity 11 may be waterproof and dustproof to form a high ingress protection cavity (that is, a cavity with a high ingress protection rating). For example, ingress protection ratings of the power cavity 10 and the heat dissipation cavity 11 may be greater than or equal to an ingress protection rating threshold (for example, IP67), so that damage to the power device 12 and the magnetic element 13 can be avoided, service lives of the power device 12 and the magnetic element 13 are prolonged, and applicability is higher. The ingress protection rating herein may usually include two numerals (for example, 67). A first numeral (for example, 6) may be used to indicate a rating of protection against ingress of dust and ingress of a foreign body to the power conversion device. The foreign body refers to an object (such as a tool and a human finger) that cannot touch a live part in the power conversion device 1. A second numeral (for example, 7) may be used to indicate a degree of sealing against ingress of moisture and ingress of water, and a larger numeral indicates a higher ingress protection rating of the cavity. The ingress protection rating threshold herein may be determined by parameters configured for the power cavity 10 and the heat dissipation cavity 11, or a threshold set by a user.

In some feasible implementations, the power cavity 10 and the heat dissipation cavity 11 may communicate with each other to form a first air duct (for example, a passage that is for air circulation and that is made of materials such as concrete and brick). In this case, air in the power cavity 10 may flow to the heat dissipation cavity 11 through the first air duct, and air in the heat dissipation cavity 11 may also flow to the power cavity 10 through the first air duct. As shown in FIG. 3, a communication port between the power cavity 10 and the heat dissipation cavity 11 may be located at upper and lower ends that are in contact with the power cavity 10 and the heat dissipation cavity 11, where the communication port refers to a communication port part between the power cavity 10 and the heat dissipation cavity 11. Optionally, the communication port between the power cavity 10 and the heat dissipation cavity 11 may also be located at left and right ends that are in contact with the power cavity 10 and the heat dissipation cavity 11. It should be noted that, a specific location of the communication port between the power cavity 10 and the heat dissipation cavity 11 may be determined by an actual placement angle of the power conversion device 1, which is not limited herein. The power device 12 is disposed in the power cavity 10, the second heat sink 15a to the second heat sink 15m are disposed in the heat dissipation cavity 11, and each of the first heat sink 14a to the first heat sink 14n may be connected to (or in contact with) the power device 12. The magnetic element 13 may be disposed in the first air duct. For example, as shown in FIG. 3, the magnetic element 13 may be disposed in the heat dissipation cavity 11.

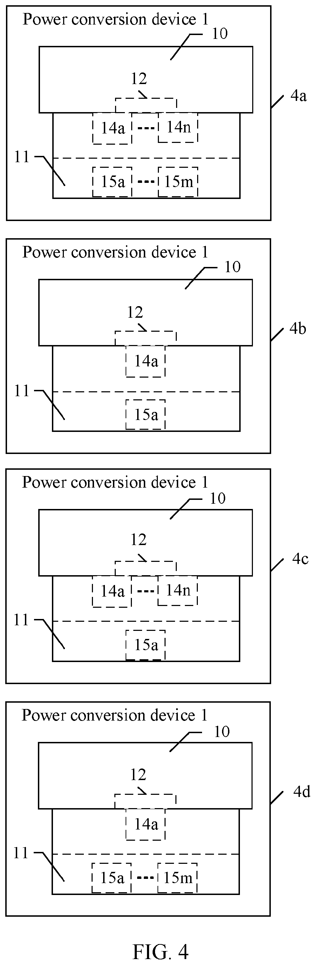

Further, for a top view of the power conversion device 1 shown in FIG. 3, refer to FIG. 4. FIG. 4 is a schematic diagram of another structure of a power conversion device according to this application. When projection regions formed after vertical projection is performed on the first heat sinks in the first heat sink 14a to the first heat sink 14n completely do not overlap or partially overlap, and when projection regions formed after vertical projection is performed on the second heat sinks in the second heat sink 15a to the second heat sink 15m completely do not overlap or partially overlap, the top view of the power conversion device 1 may be shown as 4a in FIG. 4. When projection regions formed after vertical projection is performed on the first heat sinks completely overlap, and projection regions formed after vertical projection is performed on the second heat sinks completely overlap, the top view of the power conversion device 1 may be shown as 4b in FIG. 4. When projection regions formed after vertical projection is performed on the first heat sinks completely do not overlap or partially overlap, and projection regions formed after vertical projection is performed on the second heat sinks completely overlap, the top view of the power conversion device 1 may be shown as 4c in FIG. 4. When projection regions formed after vertical projection is performed on the first heat sinks completely overlap, and when projection regions formed after vertical projection is performed on the second heat sinks completely do not overlap or partially overlap, the top view of the power conversion device 1 may be shown as 4d in FIG. 4. It should be noted that specific arrangement locations of the first heat sink 14a to the first heat sink 14n and the second heat sink 15a to the second heat sink 15m may be determined based on an actual application scenario, which is not limited herein.

In some feasible implementations, when the power conversion device 1 works, the power device 12 and the magnetic element 13 generate heat. In this case, the first heat sinks in the first heat sink 14a to the first heat sink 14n may dissipate the heat generated by the power device 12, and the second heat sinks in the second heat sink 15a to the second heat sink 15m may dissipate the heat generated by the magnetic element 13, so that the power device 12 and the magnetic element 13 work within an allowable temperature range (that is, heat dissipation is implemented). The allowable temperature range herein may be determined by parameters configured for the power device 12 and the magnetic element 13, or the allowable temperature range may be understood as a temperature range set by the user for the power device 12 and the magnetic element 13. It may be understood that, because heat consumption and temperature specifications of the power device 12 and the magnetic element 13 are greatly different, the first heat sink 14a to the first heat sink 14n and the second heat sink 15a to the second heat sink 15m may be separately disposed to rapidly dissipate the heat for the power device 12 and the magnetic element 13, thereby greatly improving a heat dissipation capability of the power conversion device 1. In addition, because the power cavity 10 and the heat dissipation cavity 11 communicate with each other, the air may circulate and flow in the two cavities, thereby improving natural heat dissipation capabilities of the power cavity 10 and the heat dissipation cavity 11, and further reducing temperatures in the two cavities to prolong service lives and improve reliability of devices in the cavities (that is, the power device 12 and the magnetic element 13). The heat dissipation capability is stronger, and applicability is high.

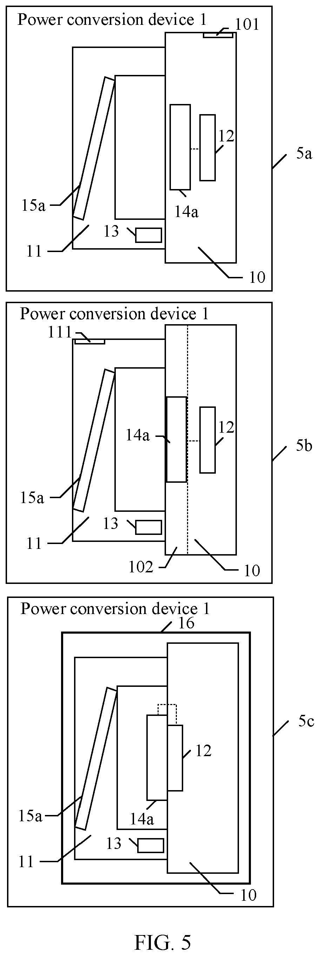

In some feasible implementations, FIG. 5 is a schematic diagram of another structure of a power conversion device according to this application. For ease of description, the following uses an example in which the power conversion device 1 includes a first heat sink (for example, the first heat sink 14a) and a second heat sink (for example, the second heat sink 15a). As shown in 5a in FIG. 5, the first heat sink 14a may be disposed in the power cavity 10 and connected to the power device 12, and the first heat sink 14a can rapidly dissipate heat for the power device 12 in the power cavity 10, thereby further improving a heat dissipation capability. A breather valve 101 may be disposed in the power cavity 10. The breather valve 101 is a valve that can ensure that the power cavity 10 and the heat dissipation cavity 11 are isolated from the atmosphere when pressure in the cavities is within a specific pressure range and that can also ensure that the power cavity 10 and the heat dissipation cavity 11 communicate with (breath) the atmosphere when pressure in the cavities exceeds or falls within the pressure range. It may be understood that, because the power cavity 10 and the heat dissipation cavity 11 communicate with each other, the breather valve 101 can balance atmospheric pressure in the power cavity 10 and the heat dissipation cavity 11 with atmospheric pressure outside the cavities, thereby ensuring air circulation inside and outside the cavities, and further improving natural heat dissipation capabilities of the power cavity 10 and the heat dissipation cavity 11. The applicability is high.

Optionally, in some feasible implementations, as shown in 5b in FIG. 5, the first heat sink 14a may be embedded in a side (for example, a cavity side 102) that is of the power cavity 10 and that faces the heat dissipation cavity 11, so that heat dissipation can be rapidly performed on the power device 12 without occupying internal space of the power cavity 10, and the applicability is higher. A breather valve 111 may further be disposed in the heat dissipation cavity 11. Because the power cavity 10 and the heat dissipation cavity 11 communicate with each other, the breather valve 111 can balance the atmospheric pressure in the power cavity 10 and the heat dissipation cavity 11 with the atmospheric pressure outside the cavities, thereby ensuring the air circulation inside and outside the cavities, and further improving the natural heat dissipation capabilities of the power cavity 10 and the heat dissipation cavity 11. It may be understood that, because the power cavity 10 and the heat dissipation cavity 11 communicate with each other, the breather valve (for example, the breather valve 101 or the breather valve 111) is disposed in either of the power cavity 10 and the heat dissipation cavity 11, to implement the air circulation inside and outside the cavities. Optionally, when the breather valve is disposed in both the power cavity 10 and the heat dissipation cavity 11, an air circulation speed inside and outside the cavities may be further improved, and the natural heat dissipation capabilities of the power cavity 10 and the heat dissipation cavity 11 are stronger. As shown in 5c in FIG. 5, the power conversion device 1 may further include a housing 16. The power cavity 10, the heat dissipation cavity 11, and the first heat sink 14a may be disposed in the housing 16, and the first heat sink 14a may be disposed outside the power cavity 10 and the heat dissipation cavity 11. This does not occupy the internal space of the power cavity 10, thereby reducing a volume of the power cavity 10. It should be noted that for specific locations of the first heat sink 14b (not shown in the figure) to the first heat sink 14n, refer to the locations of the first heat sink 14a shown in 5a, 5b, and 5c in FIG. 5, and details are not described again below.

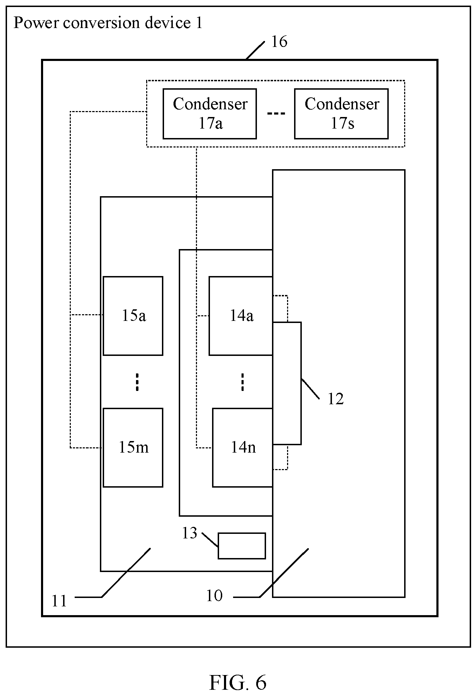

In some feasible implementations, FIG. 6 is a schematic diagram of another structure of a power conversion device according to this application. As shown in FIG. 6, the power conversion device 1 shown in FIG. 3 further includes at least one condenser (that is, one or more condensers, such as a condenser 17a to a condenser 17s). One of the condenser 17a to the condenser 17s may be connected to at least one of the first heat sinks and/or at least one of the second heat sinks by using a steam pipe and a liquid pipe, and the magnetic element 13 may be disposed in the heat dissipation cavity 11. It may be understood that, a condenser may be connected to at least one first heat sink in the first heat sink 14a to the first heat sink 14n by using the steam pipe and the liquid pipe, a condenser may be connected to at least one second heat sink in the second heat sink 15a to the second heat sink 15m by using the steam pipe and the liquid pipe, or a condenser may be connected to at least one first heat sink and at least one second heat sink by using the steam pipe and the liquid pipe. In other words, the first heat sink and the second heat sink may share a condenser, or the first heat sink and the second heat sink each use a condenser. It should be noted that specific locations of the condenser 17a to the condenser 17s may be determined based on an actual application scenario, which is not limited herein. For example, as shown in FIG. 6, the power conversion device 1 shown in FIG. 3 further includes the housing 16. The power cavity 10, the heat dissipation cavity 11, the first heat sink 14a to the first heat sink 14n, and the condenser 17a to the condenser 17s may be disposed in the housing 16. In addition, the first heat sink 14a to the first heat sink 14n and the condenser 17a to the condenser 17s are disposed outside the power cavity 10 and the heat dissipation cavity 11.

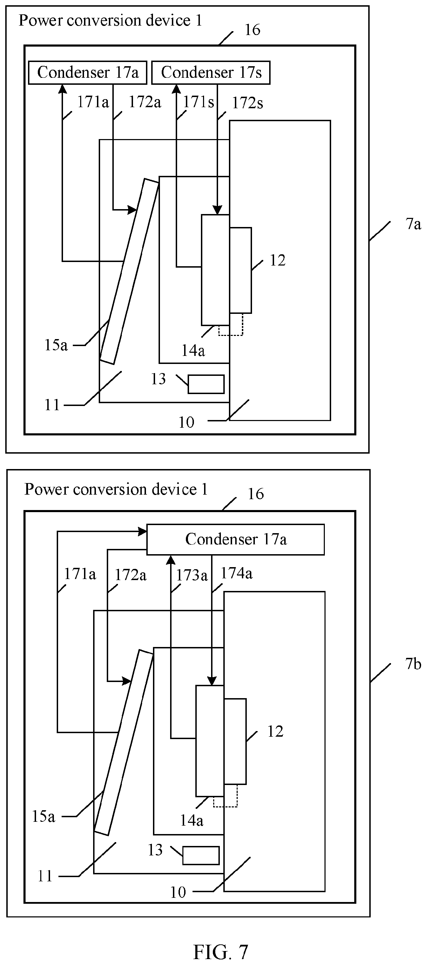

In some feasible implementations, in a heat dissipation process of the power device 12 and the magnetic element 13, the condenser may perform condensation and heat dissipation on first gas and/or second gas by using the steam pipe, and enable liquid generated after the condensation to flow back, through the liquid pipe, to the first heat sink and/or the second heat sink, thereby implementing a two-phase circulation process of gas and liquid between the first heat sink and/or the second heat sink and the condenser, and further implementing the heat dissipation for the power device 12 and the magnetic element 13. The first gas may be gas generated by the first heat sink in a heat dissipation process. In other words, the heat generated by the power device passes through the first heat sink, so that working inside the first heat sink boils, thereby generating the first gas. The second gas may be gas generated by the second heat sink in a heat dissipation process. In other words, the heat generated by the magnetic element passes through the second heat sink, so that working inside the second heat sink boils, thereby generating the second gas. It may be understood that the condenser 17a to the condenser 17s may condense and reflux the first gas generated by the first heat sink 14a to the first heat sink 14n and the second gas generated by the second heat sink 15a to the second heat sink 15m, so that the heat generated by the power device 12 and the magnetic element 13 is dissipated by using the efficient two-phase circulation process of gas and liquid, thereby greatly reducing heat dissipation costs, reducing a heat dissipation volume of the power conversion device 1, and enhancing the heat dissipation capability. In addition, output power of the power conversion device 1 can be further improved, and applicability is higher. For ease of description, the following uses an example in which the power conversion device 1 includes a first heat sink (for example, the first heat sink 14a) and a second heat sink (for example, the second heat sink 15a). FIG. 7 is a schematic diagram of another structure of a power conversion device according to this application.

In some feasible implementations, when the power conversion device 1 includes two condensers (such as the condenser 17a and the condenser 17s), as shown in 7a in FIG. 7, the condenser 17a may be connected to the second heat sink 15a (for example, a parallel flow evaporator or another type of heat sink) by using a steam pipe 171a and a liquid pipe 172a, and the condenser 17s may be connected to the first heat sink 14a (for example, a plate evaporator or another type of heat sink) by using a steam pipe 171s and a liquid pipe 172s. In this case, the condenser 17s may condense, by using the steam pipe 171s, first gas generated by the first heat sink 14a, and enable liquid generated after the condensation to flow back, through the liquid pipe 172s, to the first heat sink 14a, thereby implementing a two-phase circulation process of gas and liquid between the first heat sink 14a and the condenser 17s, and further implementing the heat dissipation for the power device 12. The condenser 17a may condense, by using the steam pipe 171a, second gas generated by the second heat sink 15a, and enable liquid generated after the condensation to flow back, through the liquid pipe 172a, to the second heat sink 15a, thereby implementing a two-phase circulation process of gas and liquid between the second heat sink 15a and the condenser 17a, and further implementing the heat dissipation for the magnetic element 13. It can be learned that, the condenser 17s may condense and reflux the first gas generated by the first heat sink 14a, and the condenser 17a may condense and reflux the second gas generated by the second heat sink 15a. Therefore, the heat of the power device 12 and the magnetic element 13 may be rapidly dissipated by using the condenser 17a and the condenser 17s respectively, thereby improving a heat dissipation capability per unit weight of the power conversion device 1, reducing a heat dissipation cost per unit of the power conversion device 1, and improving heat dissipation effect.

In some feasible implementations, when the power conversion device 1 includes one condenser (such as the condenser 17a), as shown in 7b in FIG. 7, the condenser 17a may be connected to the second heat sink 15a by using the steam pipe 171a and the liquid pipe 172a, and the condenser 17a may be connected to the first heat sink 14a by using a steam pipe 173a and a liquid pipe 174a. In this case, the condenser 17a may condense, by using the steam pipe 173a, the first gas generated by the first heat sink 14a, and enable the liquid generated after the condensation to flow back, through the liquid pipe 174a, to the first heat sink 14a, thereby implementing a two-phase circulation process of gas and liquid between the first heat sink 14a and the condenser 17a, and further implementing the heat dissipation for the power device 12. The condenser 17a may condense, by using the steam pipe 171a, the second gas generated by the second heat sink 15a, and enable liquid generated after the condensation to flow back, through the liquid pipe 172a, to the second heat sink 15a, thereby implementing a two-phase circulation process of gas and liquid between the second heat sink 15a and the condenser 17a, and further implementing the heat dissipation for the magnetic element 13. It can be learned that the condenser 17a may separately condense and reflux the first gas generated by the first heat sink 14a and the second gas generated by the second heat sink 15a. In other words, the power device 12 and the magnetic element 13 may share the condenser 17a to perform the heat dissipation. A heat dissipation cost is low, and a heat dissipation capability is strong. It should be noted that for working processes from the first heat sink 14b (not shown in the figure) to the first heat sink 14n, refer to the working process of the first heat sink 14a in the embodiment corresponding to FIG. 7. For working processes from the second heat sink 15b (not shown in the figure) to the second heat sink 15m, refer to the working process of the second heat sink 15a in the embodiment corresponding to FIG. 7. Details are not described below.

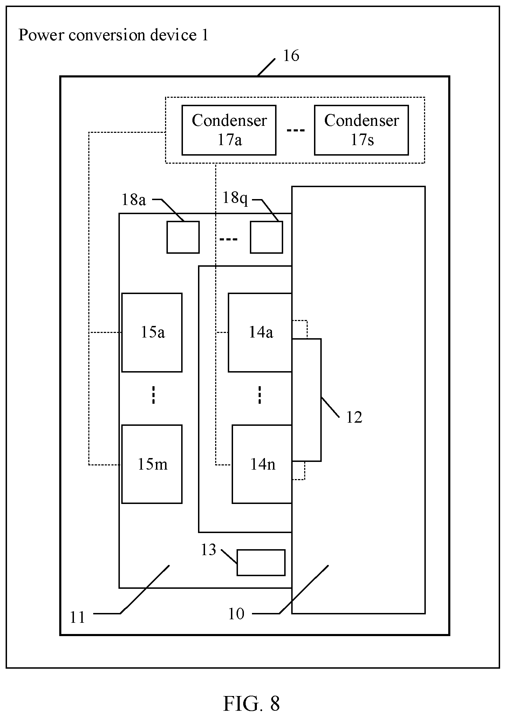

FIG. 8 is a schematic diagram of another structure of a power conversion device according to this application. In some feasible implementation, as shown in FIG. 8, the power conversion device 1 shown in FIG. 6 further includes at least one first fan disposed in the heat dissipation cavity 11 (that is, one or more first fans, such as a first fan 18a to a first fan 18q). The first fan herein may be understood as an internal circulation fan configured to implement airflow circulation in the power cavity 10 and the heat dissipation cavity 11. The first fan 18a to the first fan 18q may push airflow, so that the heat generated by the magnetic element 13 passes through each of the second heat sink 15a to the second heat sink 15m, and further, the second heat sinks can rapidly dissipate heat for the magnetic element 13. Optionally, the power conversion device 1 further includes another component (not shown in the figure) disposed in the power cavity 10 in addition to the power device 12. In this case, the first fan 18a to the first fan 18q may push the airflow, so that heat (namely, heat consumption) generated by the another component passes through each of the second heat sink 15a to the second heat sink 15m, and further, the second heat sinks can rapidly dissipate the heat for the another component. It may be understood that, airflow circulation in the power cavity 10 and the heat dissipation cavity 11 may be implemented through flow mixing of the first fan 18a to the first fan 18q, so that the heat generated by the magnetic element 13 passes through the second heat sinks, thereby rapidly dissipating heat for the magnetic element 13. Heat dissipation effect is better, and applicability is higher.

Optionally, in some feasible implementations, the first fan 18a to the first fan 18q may further dissipate the heat generated by the magnetic element 13 and heat generated by each of the second heat sink 15a to the second heat sink 15m, so that the heat generated by the magnetic element 13 may be dissipated simultaneously by using the second heat sinks and the first fan, and a heat dissipation capability and heat dissipation efficiency are further improved. In addition, the second heat sinks also generate the heat in a heat dissipation process. In this case, the heat generated by the second heat sinks may be dissipated by using the first fan, thereby prolonging a service life and improving reliability of the second heat sink, improving a heat dissipation capability of the entire power conversion device 1, and enhancing the applicability.

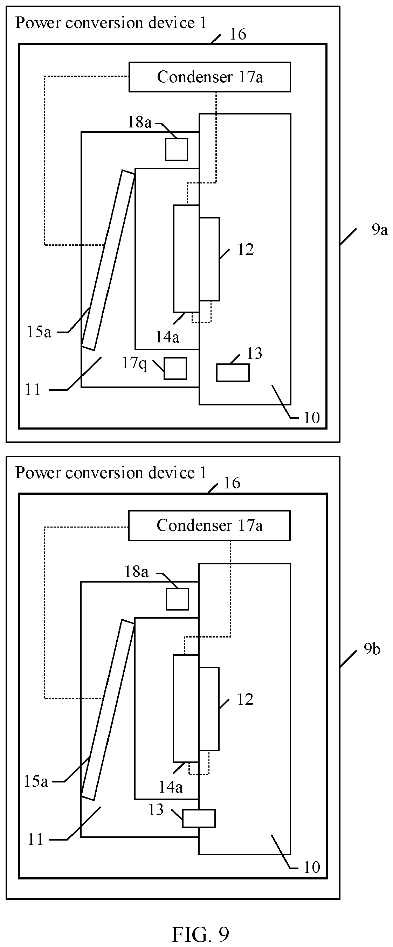

For ease of description, the following uses an example in which the power conversion device 1 includes a condenser (the condenser 17a). FIG. 9 is a schematic diagram of another structure of a power conversion device according to this application. In some feasible implementations, when the power conversion device 1 includes two first fans, as shown in 9a in FIG. 9, the power conversion device 1 shown in 7b in FIG. 7 further includes the first fan 18a and the first fan 18q. The heat dissipation cavity 11 is a C-shaped cavity, the first fan 18a is disposed at a first communication end between the C-shaped cavity and the power cavity 10, and the first fan 18q is disposed at a second communication end between the C-shaped cavity and the power cavity 10. In this case, the magnetic element 13 may be disposed in the power cavity 10. The first communication end and the second communication end herein may be understood as two ends at which the C-shaped cavity is in contact with the power cavity 10. It may be understood that the first fan 18a and the first fan 18q may enhance air circulation (that is, internal circulation flow) in the power cavity 10 and the heat dissipation cavity 11, to quickly dissipate heat for the magnetic element 13, the second heat sink 15a, and another component in the power cavity 11. A heat dissipation capability is stronger, and heat dissipation efficiency is higher.

Optionally, in some feasible implementations, when the power conversion device 1 includes one first fan, as shown in 9b in FIG. 9, the power conversion device 1 shown in 7b in FIG. 7 further includes the first fan 18a. The heat dissipation cavity 11 is the C-shaped cavity, the first fan 18a may be disposed at the first communication end between the C-shaped cavity and the power cavity 10, the magnetic element 13 may be disposed at the second communication end between the C-shaped cavity and the power cavity 10. In this case, one part of the magnetic element 13 may be disposed in the power cavity 10, and the other part of the magnetic element 13 may be disposed in the C-shaped cavity (that is, the heat dissipation cavity 11). It may be understood that the first fan 18a and the second heat sink 15a may simultaneously dissipate the heat for the magnetic element 13, and the first fan 18a may further dissipate the heat for the second heat sink 15a and the another device in the power cavity 11, to implement heat dissipation effect by sharing the first fan 18a. This further reduces heat dissipation costs and enhances applicability.

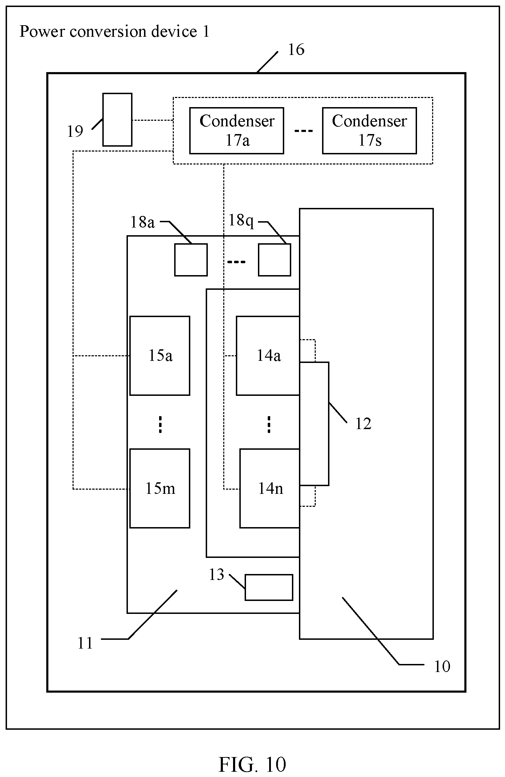

FIG. 10 is a schematic diagram of another structure of a power conversion device according to this application. In some feasible implementations, as shown in FIG. 10, the power conversion device 1 shown in FIG. 8 further includes a second fan 19 disposed in the housing 16, and the second fan 19 is disposed outside the power cavity 10 and the heat dissipation cavity 11. The second fan 19 may be understood as an external circulation fan configured to implement airflow circulation outside the power cavity 10 and the heat dissipation cavity 11. During heat dissipation for the power device 12 and the magnetic element 13, heat is also generated by the condenser 17a to the condenser 17s and the first heat sink 14a to the first heat sink 14n. In this case, the second fan 19 may dissipate the heat generated by each of the condenser 17a to the condenser 17s and the heat generated by each of the first heat sink 14a to the first heat sink 14n, thereby increasing flow rates of airflow passing through each condenser and each first heat sink, enhancing heat dissipation effect, and enhancing a heat dissipation capability. Optionally, the second fan 19 may also be connected to each of the condenser 17a to the condenser 17s through a second air duct, and the second air duct herein may be understood as an air duct of each of the condensers. The second air duct may be set to air intake from front (left side) and air exhaust from rear (right side) or air intake from front and air exhaust from top (top). This may be specifically determined based on an actual application scenario, and is not limited herein. The second fan 19 may further dissipate the heat generated by each of the condenser 17a to the condenser 17s through the second air duct, which further enhances the heat dissipation effect and the heat dissipation capability, and has the stronger applicability. Optionally, the power conversion device 1 may further include a control unit (not shown in the figure), and the control unit may control rotational speeds of each of the first fan 18a to the first fan 18q and the second fan 19 based on target power required by the power conversion device 1, so that output power of the power conversion device 1 reaches the target power, thereby improving work efficiency of the power conversion device 1. Larger output power of the power conversion device 1 indicates a higher rotational speed of each fan. On the contrary, smaller output power of the power conversion device 1 indicates a lower rotational speed of each fan.

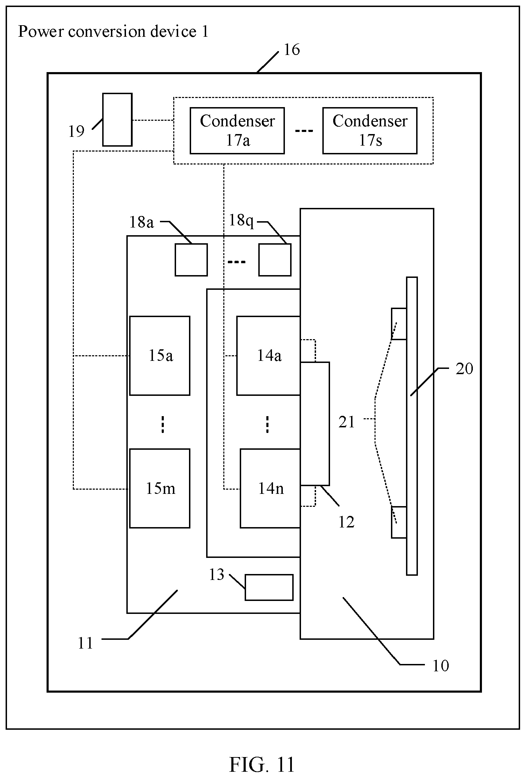

FIG. 11 is a schematic diagram of another structure of a power conversion device according to this application. In some feasible implementations, as shown in FIG. 11, the power conversion device 1 shown in FIG. 10 further includes other devices disposed in the power cavity 10 in addition to the power device 12. The other devices may include but are not limited to a board 20 and a resistor-capacitor element 21 disposed on the board 20. In this application, electronic components that are in the power conversion device 1 and that are configured to block electron flow or store an electron may be collectively referred to as the resistor-capacitor element 21. The resistor-capacitor element 21 may include but is not limited to a resistor and a capacitor. In a working process of the power conversion device 1, the board 20 and the resistor-capacitor element 21 also generate heat. The first fan 18a to the first fan 18q may push air, so that the heat generated by the board 20 and the heat generated by the resistor-capacitor element 21 pass through the second heat sink 15a to the second heat sink 15m. In this case, the second heat sink 15a to the second heat sink 15m may dissipate the heat generated by the board 20 and the heat generated by the resistor-capacitor element 21, and a heat dissipation capability is stronger. Optionally, the second heat sink 15a to the second heat sink 15m and the condenser 17a to the condenser 17s may dissipate the heat generated by the board 20 and the heat generated by the resistor-capacitor element 21 by using an efficient two-phase circulation process of gas and liquid, thereby greatly reducing heat dissipation costs and reducing a heat dissipation volume of the device, and improving output power of the power conversion device. The second heat sink 15a to the second heat sink 15m generate heat in a heat dissipation process of the board 20 and the resistor-capacitor element 21. In this case, the first fan 18a to the first fan 18q may further dissipate the heat generated by the second heat sink 15a to the second heat sink 15m, the heat generated by the board 20, and the heat generated by the resistor-capacitor element 21. This further enhances heat dissipation effect and the heat dissipation capability, and enhances applicability.

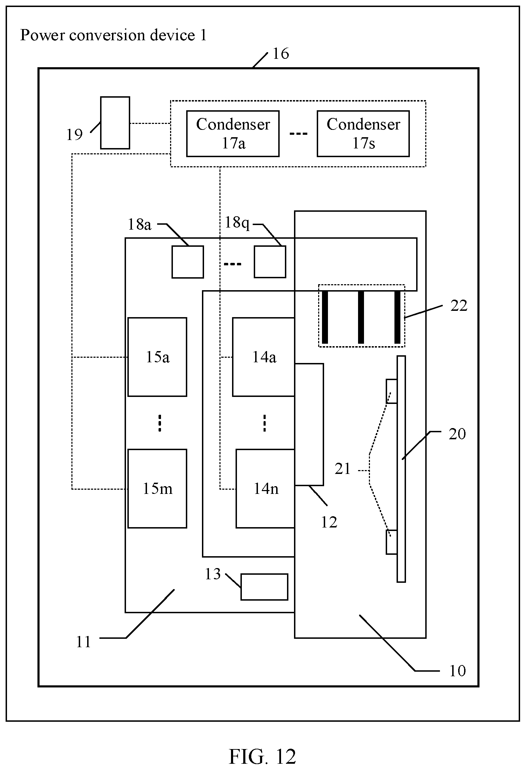

FIG. 12 is a schematic diagram of another structure of a power conversion device according to this application. In some feasible implementations, as shown in FIG. 12, the power conversion device 1 shown in FIG. 11 further includes an airflow distribution component 22. The airflow distribution component 22 may be connected to the first air duct, or the airflow distribution component 22 may be disposed in the first air duct. The airflow distribution component 22 herein may be disposed in the power cavity 10. Alternatively, when the heat dissipation cavity 11 is a C-shaped cavity, the airflow distribution component 22 may be disposed at one end of the C-shaped cavity, and the airflow distribution component 22 is inserted (or deeply penetrates) into the power cavity 10. In this application, a device that is in the power conversion device 1 and that is configured to perform directional airflow distribution may be referred to as the airflow distribution component 22. The airflow distribution component 22 may be configured to distribute, through the first air duct, airflow generated by each of the first fan 18a to the first fan 18q to the board 20 and the resistor-capacitor element 21, thereby dissipating heat for the board 20 and the resistor-capacitor element 21. Heat dissipation effect is better, and a heat dissipation capability is stronger.

In this application, because the heat consumption and the temperature specifications of the power device 12 and the magnetic element 13 are greatly different, the first heat sink and the second heat sink may be separately disposed to dissipate the heat for the power device 12 and the magnetic element 13, thereby greatly improving the heat dissipation capability of the power conversion device 1. In addition, because the power cavity 10 and the heat dissipation cavity 11 communicate with each other, the air may circulate and flow in the two cavities, thereby improving the natural heat dissipation capabilities of the power cavity 10 and the heat dissipation cavity 11, and further reducing the temperatures in the two cavities to prolong the service lives and improve the reliability of devices in the cavities. The heat dissipation capability of the power conversion device 1 is stronger, and the applicability is high.

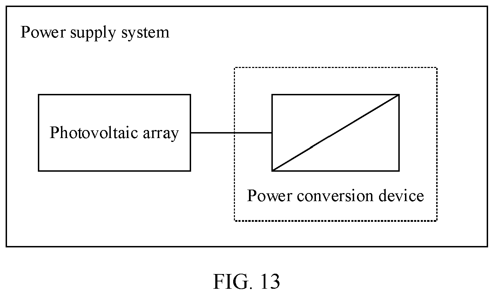

FIG. 13 is a schematic diagram of a structure of a power supply system according to this application. In some feasible implementations, as shown in FIG. 13, the power supply system may include a photovoltaic array and a power conversion device (for example, the power conversion device 1 shown in FIG. 3 to FIG. 12) coupled (for example, directly connected or indirectly connected by using another component) to the photovoltaic array. In this case, the power supply system can be understood as a photovoltaic system. The power conversion device may include but is not limited to a photovoltaic inverter, a direct current combiner box, an alternating current combiner box, and/or a DC-to-DC converter. Electronic components in the photovoltaic inverter, the direct current combiner box, the alternating current combiner box, and/or the DC-to-DC converter herein may include but are not limited to the power device 12, the magnetic element 13, and another component in the power conversion device 1. The power conversion device may supply power to an alternating current grid based on a direct current voltage provided by the photovoltaic array. Because the power conversion device has a strong heat dissipation capability and low heat dissipation costs, a service life can be prolonged and reliability of electronic components in the power conversion device can be improved, thereby ensuring that the power conversion device can work normally. This improves power supply efficiency of the power supply system, and has strong applicability.

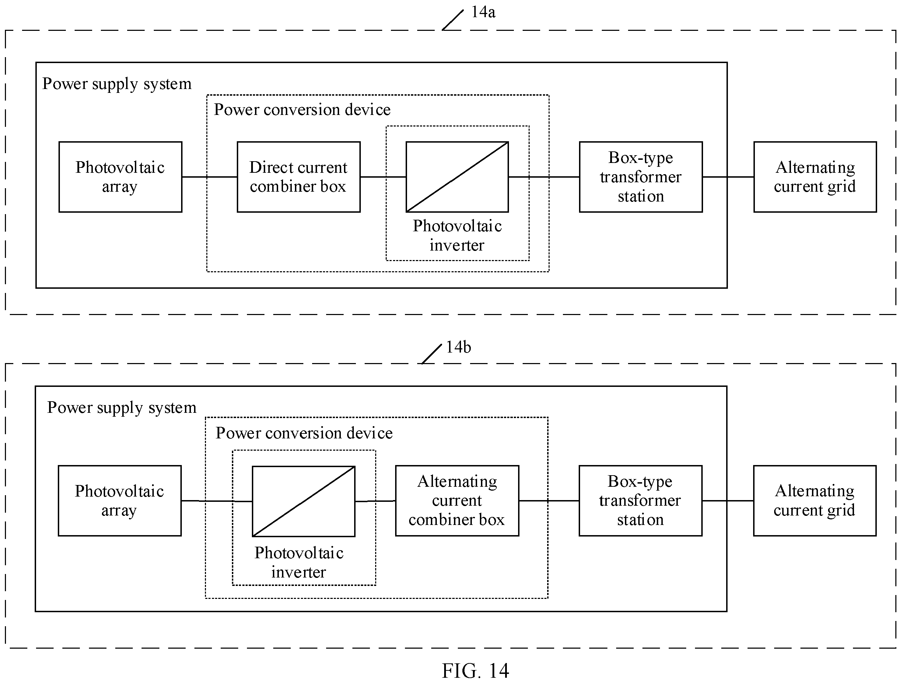

In some feasible implementations, FIG. 14 is a schematic diagram of another structure of a power supply system according to this application. In a photovoltaic power supply application scenario, as shown in 14a in FIG. 14, the power conversion device in FIG. 13 includes the direct current combiner box and the photovoltaic inverter connected to the direct current combiner box. The power supply system in FIG. 13 further includes a box-type transformer station (which may be referred to as a box-type transformer station for short), the photovoltaic inverter may be connected to an input end of the box-type transformer station, and an output end of the box-type transformer station may be connected to an alternating current grid. The box-type transformer station is a high-voltage switchgear, power distribution transformer, and low-voltage switchgear, and organically combines functions, for example, high-voltage power receiving, transformer voltage step-down, and low-voltage power distribution based on a specific wiring scheme, and installs the functions in a transformer station (or power distribution station) in a box-type shell. In a process of supplying power to the alternating current grid, the direct current combiner box may combine direct current voltages provided by photovoltaic strings in the photovoltaic array and output the direct current voltage to the photovoltaic inverter, and the photovoltaic inverter (for example, a central inverter) may output, based on a combined direct current voltage, an alternating current voltage to the box-type transformer station. In this case, the box-type transformer station may supply, based on the alternating current voltage input by the photovoltaic inverter, power to the alternating current grid. In the power supply process, electronic devices in the direct current combiner box and the photovoltaic inverter generate heat. Because the direct current combiner box and the photovoltaic inverter have strong heat dissipation capabilities and low heat dissipation costs, the heat of the electronic components can be rapidly dissipated and service lives can be prolonged and reliability of the electronic components can be improved. Therefore, it is ensured that the direct current combiner box and the photovoltaic inverter can work normally, power supply efficiency of the power supply system is further improved, and applicability is higher.

Optionally, in some feasible implementations, as shown in 14b in FIG. 14, the power conversion device in FIG. 13 includes the photovoltaic inverter and an alternating current combiner box connected to the photovoltaic inverter. The power supply system in FIG. 13 further includes a box-type transformer station, the alternating current combiner box may be connected to an input end of the box-type transformer station, and an output end of the box-type transformer station may be connected to an alternating current grid. In a process of supplying power to the alternating current grid, the photovoltaic inverter may provide, based on a direct current voltage provided by the photovoltaic array, an alternating current voltage to the alternating current combiner box, and the alternating current combiner box may combine the alternating current voltage input by the photovoltaic inverter (for example, a string inverter) and output the alternating current voltage to the box-type transformer station. In this case, the box-type transformer station may supply, based on a combined alternating current voltage, power to the alternating current grid. In the power supply process, electronic devices in the photovoltaic inverter and the alternating current combiner box generate heat. Because the photovoltaic inverter and the alternating current combiner box have strong heat dissipation capabilities and low heat dissipation costs, the heat of the electronic components can be rapidly dissipated and service lives can be prolonged and reliability of the electronic components can be improved. Therefore, it is ensured that the photovoltaic inverter and the alternating current combiner box can work normally, power supply efficiency of the power supply system is further improved, and applicability is higher.

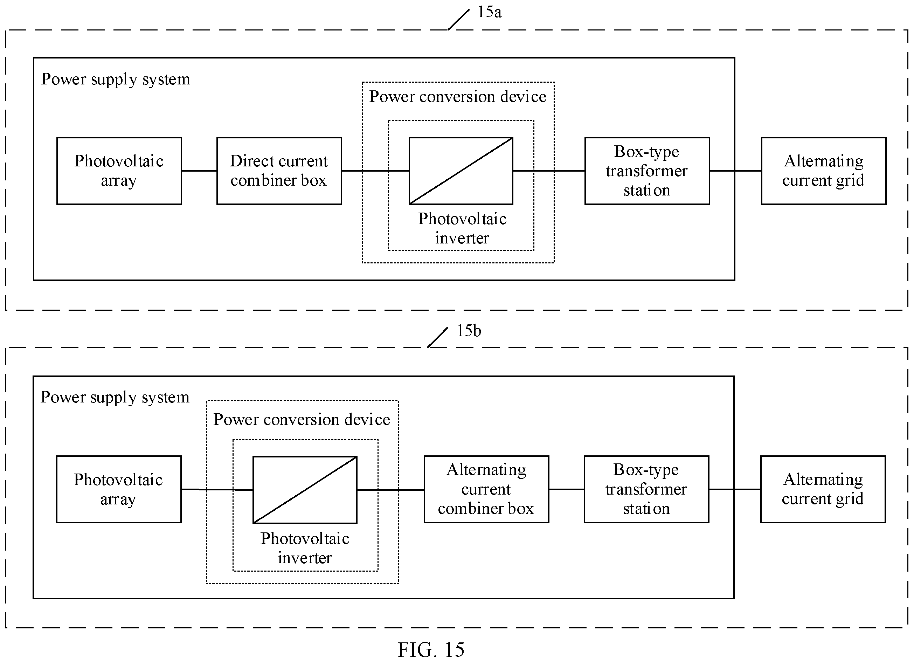

In some feasible implementations, FIG. 15 is a schematic diagram of another structure of a power supply system according to this application. In a photovoltaic power supply application scenario, as shown in 15a in FIG. 15, the power conversion device in FIG. 13 may be the photovoltaic inverter. The power supply system in FIG. 13 further includes the direct current combiner box and a box-type transformer station, the photovoltaic array may be connected to the photovoltaic inverter through the direct current combiner box, the photovoltaic inverter may be connected to an input end of the box-type transformer station, and an output end of the box-type transformer station may be connected to an alternating current grid for supplying power to the alternating current grid. Optionally, as shown in 15b in FIG. 15, the power conversion device in FIG. 13 may be the photovoltaic inverter. The power supply system in FIG. 13 further includes the alternating current combiner box and a box-type transformer station, the photovoltaic array may be connected to the alternating current combiner box through the photovoltaic inverter, the alternating current combiner box may be connected to an input end of the box-type transformer station, and an output end of the box-type transformer station may be connected to an alternating current grid for supplying power to the alternating current grid. In the process of supplying power to the alternating current grid, electronic components in the photovoltaic inverter generate heat. Because the photovoltaic inverter has a strong heat dissipation capability and low heat dissipation costs, the heat of the electronic components can be rapidly dissipated and service lives can be prolonged and reliability of the electronic components can be improved. Therefore, it is ensured that the photovoltaic inverter can work normally, power supply efficiency of the power supply system is further improved, and applicability is higher.

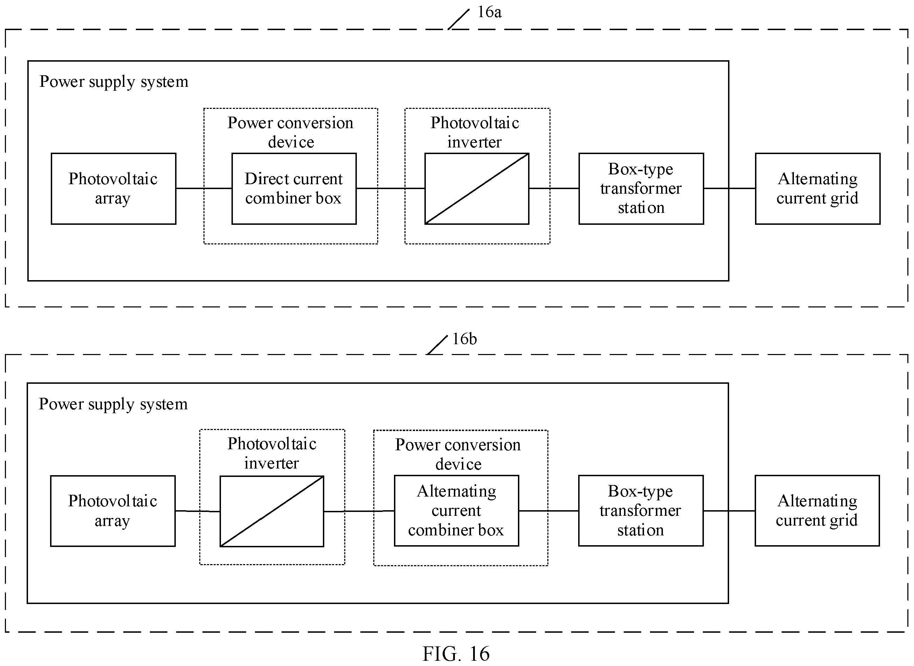

In some feasible implementations, FIG. 16 is a schematic diagram of another structure of a power supply system according to this application. In a photovoltaic power supply application scenario, as shown in 16a in FIG. 16, the power conversion device in FIG. 13 may be the direct current combiner box. The power supply system in FIG. 13 further includes the photovoltaic inverter and a box-type transformer station, the photovoltaic array may be connected to the photovoltaic inverter through the direct current combiner box, the photovoltaic inverter may be connected to an input end of the box-type transformer station, and an output end of the box-type transformer station may be connected to an alternating current grid for supplying power to the alternating current grid. In the process of supplying power to the alternating current grid, electronic components in the direct current combiner box generate heat. Because the direct current combiner box has a strong heat dissipation capability and low heat dissipation costs, the heat of the electronic components can be rapidly dissipated and service lives can be prolonged and reliability of the electronic components can be improved. Therefore, it is ensured that the direct current combiner box can work normally, power supply efficiency of the power supply system is further improved, and applicability is higher. Optionally, as shown in 16b in FIG. 16, the power conversion device in FIG. 13 may be the alternating current combiner box. The power supply system in FIG. 13 further includes the photovoltaic inverter and a box-type transformer station, the photovoltaic array may be connected to the alternating current combiner box through the photovoltaic inverter, the alternating current combiner box may be connected to an input end of the box-type transformer station, and an output end of the box-type transformer station may be connected to an alternating current grid for supplying power to the alternating current grid. In the process of supplying power to the alternating current grid, electronic components in the alternating current combiner box generate heat. Because the alternating current combiner box has a strong heat dissipation capability and low heat dissipation costs, the heat of the electronic components can be rapidly dissipated and service lives can be prolonged and reliability of the electronic components can be improved. Therefore, it is ensured that the alternating current combiner box can work normally, power supply efficiency of the power supply system is further improved, and applicability is higher.

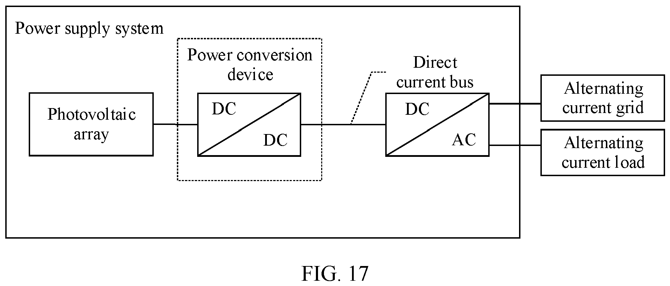

In some feasible implementations, FIG. 17 is a schematic diagram of another structure of a power supply system according to this application. In a photovoltaic power supply application scenario, as shown in FIG. 17, the power conversion device in FIG. 13 may be the DC-to-DC converter. The power supply system in FIG. 13 may further include a direct current bus and a DC-to-AC converter, the DC-to-DC converter may be connected to an input end of the DC-to-AC converter through the direct current bus, and an output end of the DC-to-AC converter may be connected to an alternating current grid or an alternating current load. In a process of supplying power to the alternating current grid or the alternating current load, the DC-to-DC converter may convert a direct current voltage provided by the photovoltaic array into a target direct current voltage, and output the target direct current voltage to the DC-to-AC converter through the direct current bus. In this case, the DC-to-AC converter may convert the target direct current voltage into an alternating current voltage, and supply power to the alternating current grid or the alternating current load based on the alternating current voltage. In the power supply process, electronic components in the DC-to-DC converter generate heat. Because the DC-to-DC converter has a strong heat dissipation capability and low heat dissipation costs, the heat of the electronic components can be rapidly dissipated and service lives can be prolonged and reliability of the electronic components can be improved. Therefore, it is ensured that the DC-to-DC converter can work normally, power supply efficiency of the power supply system is further improved, and applicability is higher.

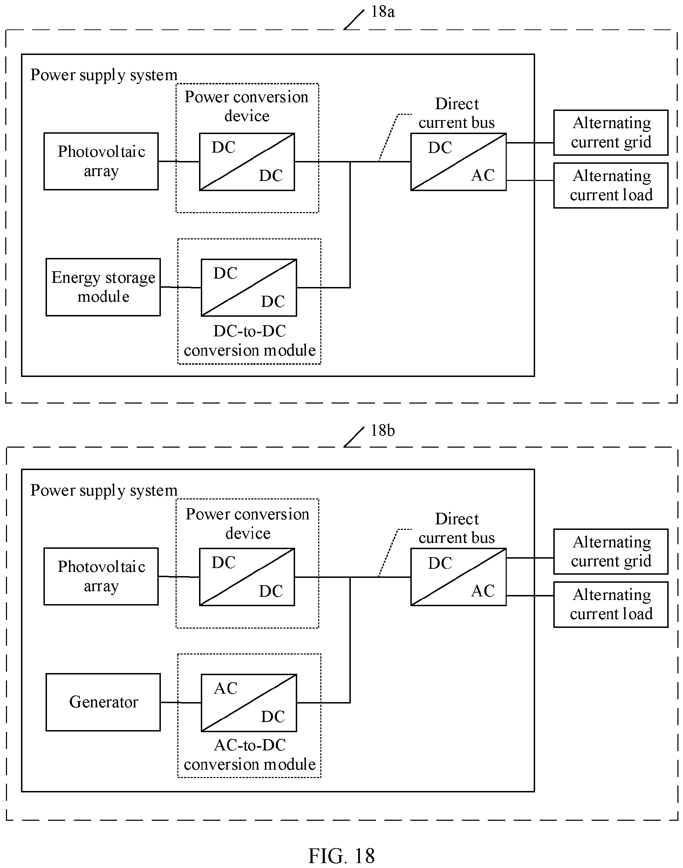

In some feasible implementations, FIG. 18 is a schematic diagram of another structure of a power supply system according to this application. In a solar energy storage hybrid power supply application scenario, as shown in 18a in FIG. 18, the power supply system in FIG. 17 further includes an energy storage module and a DC-to-DC conversion module connected to the energy storage module, and the DC-to-DC conversion module may be connected to the input end of the DC-to-AC converter through the direct current bus. The energy storage module may include at least one battery rack, and one battery rack may include a plurality of battery strings connected in series. The battery string may be a battery pack, and one battery pack may include one or more battery cells (a voltage of the battery cell usually ranges from 2.5 V to 4.2 V) connected in series and parallel, to form a smallest energy storage and management unit. In a process of supplying power to an alternating current grid or an alternating current load, the DC-to-DC conversion module may convert, into a target direct current voltage, a direct current voltage provided by the energy storage module, and output the target direct current voltage to the DC-to-AC converter through the direct current bus. In this case, the DC-to-AC converter may convert, into an alternating current voltage, the target direct current voltage input by the DC-to-DC conversion module and a target direct current voltage input by the DC-to-DC converter, and supply power to the alternating current grid or the alternating current load based on the alternating current voltage. The power supply efficiency is higher.

Optionally, in some feasible implementations, in a solar-wind hybrid power supply application scenario, as shown in 18b in FIG. 18, the power supply system in FIG. 17 further includes a generator and an AC-to-DC conversion module connected to the generator, and the AC-to-DC conversion module may be connected to the input end of the DC-to-AC converter through the direct current bus. In a process of supplying power to an alternating current grid or an alternating current load, the AC-to-DC conversion module may convert, into a direct current voltage, an alternating current provided by the generator, and output a target direct current voltage to the DC-to-AC converter through the direct current bus. In this case, the DC-to-AC converter may convert, into the alternating current voltage, the direct current voltage input by the AC-to-DC conversion module and the target direct current voltage input by the DC-to-DC converter, and supply power to the alternating current grid or the alternating current load based on the alternating current voltage. The power supply efficiency is higher. Optionally, the DC-to-AC converter may further supply power to the alternating current grid or the alternating current load based on the direct current voltage provided by the photovoltaic array, the direct current voltage provided by the energy storage module, and/or the alternating current voltage provided by the generator, thereby improving system power supply flexibility and further improving system power supply efficiency.

In this application, in the process of supplying power to the alternating current grid or the alternating current load, the electronic components in the power conversion device generate heat. Because the power conversion device has the strong heat dissipation capability and the low heat dissipation costs, the heat of the electronic components can be rapidly dissipated and the service lives can be prolonged and the reliability of the electronic components can be improved. Therefore, it is ensured that the power conversion device can work normally, the power supply efficiency and power supply reliability of the system are further improved, and the applicability is higher.

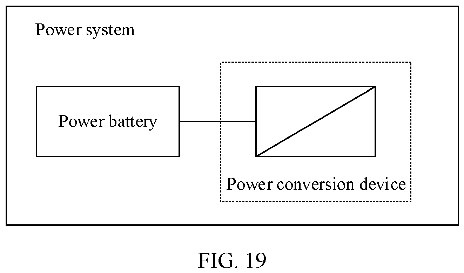

In some feasible implementations, FIG. 19 is a schematic diagram of a structure of a power system according to this application. As shown in FIG. 19, the power system includes a power battery and a power conversion device (the power conversion device 1 shown in FIG. 3 to FIG. 12, for example, the inverter) connected to the power battery. The power system may be applicable to an electric device. The electric device may include, but is not limited to, an electric vehicle, electric amusement equipment, an electric train, an electric bicycle, a golf cart, ventilation equipment, stamping equipment, crystal equipment, a water pump, and various machine tools. It is assumed that the power system is disposed in the electric vehicle, and the electric vehicle may further include a motor connected to the power system. The power conversion device may drive the motor to work based on a direct current voltage provided by the power battery, so that the electric vehicle runs. In the process of driving the motor, electronic components in the power conversion device generate heat. Because the power conversion device has a strong heat dissipation capability and low heat dissipation costs, the heat of the electronic components can be rapidly dissipated and service lives can be prolonged and reliability of the electronic components can be improved. Therefore, it is ensured that the power conversion device can work normally to drive the motor, work efficiency and reliability of the power system are further improved, and applicability is higher.

The foregoing descriptions are merely specific implementations of the present invention, but are not intended to limit the protection scope of the present invention. Any variation or replacement readily figured out by a person skilled in the art within the technical scope disclosed in the present invention shall fall within the protection scope of the present invention. Therefore, the protection scope of the present invention shall be subject to the protection scope of the claims.

## Claims

1. A power supply system, wherein the power supply system comprises a photovoltaic array and a power conversion device coupled to the photovoltaic array, and the power conversion device comprises a power cavity, a heat dissipation cavity, a power device, a magnetic element, at least one first heat sink, and at least one second heat sink, the power cavity and the heat dissipation cavity communicate with each other to form a first air duct, the power device is disposed in the power cavity, the at least one second heat sink is disposed in the heat dissipation cavity, first heat sinks are connected to the power device, and the magnetic element is disposed in the first air duct; and
the first heat sinks are configured to dissipate heat generated by the power device when the power conversion device works, and second heat sinks are configured to dissipate heat generated by the magnetic element when the power conversion device works.

2. The power supply system according to claim 1, wherein the power conversion device further comprises at least one condenser, and a condenser is connected to at least one of the first heat sinks and/or at least one of the second heat sinks by using a steam pipe and a liquid pipe; and
the condenser is configured to: condense first gas and/or second gas by using the steam pipe, and enable liquid generated after the condensation to flow back, through the liquid pipe, to the first heat sink and/or the second heat sink, the first gas is gas generated by the first heat sink in a heat dissipation process, and the second gas is gas generated by the second heat sink in a heat dissipation process.

3. The power supply system according to claim 1 or 2, wherein the magnetic element is disposed in the power cavity or the heat dissipation cavity.

4. The power supply system according to claim 1 or 2, wherein one part of the magnetic element is disposed in the power cavity, and the other part of the magnetic element is disposed in the heat dissipation cavity.

5. The power supply system according to any one of claims 1 to 4, wherein the at least one first heat sink is disposed in the power cavity.

6. The power supply system according to any one of claims 1 to 4, wherein the power conversion device further comprises a housing, the power cavity, the heat dissipation cavity, and the at least one first heat sink are disposed in the housing, and the at least one first heat sink is disposed outside the power cavity and the heat dissipation cavity.

7. The power supply system according to any one of claims 1 to 4, wherein at least one heat sink is embedded in a side that is of the power cavity and that faces the heat dissipation cavity.

8. The power supply system according to any one of claims 1 to 7, wherein the power conversion device further comprises at least one first fan disposed in the heat dissipation cavity; and
the first fan is configured to push airflow, so that the heat generated by the magnetic element passes through the second heat sinks.

9. The power supply system according to claim 8, wherein the first fan is further configured to dissipate the heat generated by the magnetic element and heat generated by the second heat sinks.

10. The power supply system according to claim 8 or 9, wherein the heat dissipation cavity is a C-shaped cavity, the first fan is separately disposed at a first communication end and a second communication end between the C-shaped cavity and the power cavity, and the magnetic element is disposed in the power cavity.

11. The power supply system according to claim 8 or 9, wherein the heat dissipation cavity is a C-shaped cavity, the first fan is disposed at a first communication end between the C-shaped cavity and the power cavity, and the magnetic element is disposed at a second communication end between the C-shaped cavity and the power cavity.

12. The power supply system according to any one of claims 8 to 11, wherein the power conversion device further comprises an airflow distribution component, a board, and a resistor-capacitor element disposed on the board, the airflow distribution component is connected to the first air duct, and the board and the resistor-capacitor element are disposed in the power cavity; and
the airflow distribution component is configured to distribute, through the first air duct, airflow generated by first fans to the board and the resistor-capacitor element, to dissipate heat for the board and the resistor-capacitor element.

13. The power supply system according to claim 12, wherein the airflow distribution component is disposed in the power cavity.

14. The power supply system according to claim 12, wherein the heat dissipation cavity is the C-shaped cavity, the airflow distribution component is disposed at one end of the C-shaped cavity, and the airflow distribution component is inserted into the power cavity.

15. The power supply system according to any one of claims 1 to 14, wherein the power conversion device further comprises the housing, and a second fan and the at least one condenser that are disposed in the housing, and the condenser is connected to the at least one of the first heat sinks and/or the at least one of the second heat sinks by using the steam pipe and the liquid pipe; and
the second fan is disposed outside the power cavity and the heat dissipation cavity, and is configured to dissipate heat generated by condensers and heat generated by the first heat sinks.

16. The power supply system according to claim 15, wherein the second fan is connected to the condensers through a second air duct, and is configured to dissipate, through the second air duct, the heat generated by the condensers.

17. The power supply system according to any one of claims 1 to 16, wherein the power cavity and the heat dissipation cavity are waterproof and dustproof to form a high ingress protection cavity.

18. The power supply system according to any one of claims 1 to 17, wherein a breather valve is disposed in the power cavity or the heat dissipation cavity.

19. The power supply system according to any one of claims 1 to 18, wherein the power conversion device comprises a photovoltaic inverter, a direct current combiner box, an alternating current combiner box, and/or a direct current DC-to-DC converter.

20. The power supply system according to any one of claims 1 to 19, wherein the power conversion device comprises the direct current combiner box and the photovoltaic inverter connected to the direct current combiner box, the power supply system further comprises a box-type transformer station, the photovoltaic inverter is connected to an input end of the box-type transformer station, and an output end of the box-type transformer station is connected to an alternating current grid.

21. The power supply system according to any one of claims 1 to 19, wherein the power conversion device comprises the photovoltaic inverter and the alternating current combiner box connected to the photovoltaic inverter, the power supply system further comprises a box-type transformer station, the alternating current combiner box is connected to an input end of the box-type transformer station, and an output end of the box-type transformer station is connected to an alternating current grid.

22. The power supply system according to any one of claims 1 to 19, wherein the power conversion device is the photovoltaic inverter, the power supply system further comprises the direct current combiner box and a box-type transformer station, the photovoltaic array is connected to the photovoltaic inverter through the direct current combiner box, the photovoltaic inverter is connected to an input end of the box-type transformer station, and an output end of the box-type transformer station is connected to an alternating current grid.

23. The power supply system according to any one of claims 1 to 19, wherein the power conversion device is the photovoltaic inverter, the power supply system further comprises the alternating current combiner box and a box-type transformer station, the photovoltaic array is connected to the alternating current combiner box through the photovoltaic inverter, the alternating current combiner box is connected to an input end of the box-type transformer station, and an output end of the box-type transformer station is connected to an alternating current grid.

24. The power supply system according to any one of claims 1 to 19, wherein the power conversion device is the direct current combiner box, the power supply system further comprises the photovoltaic inverter and a box-type transformer station, the photovoltaic array is connected to the photovoltaic inverter through the direct current combiner box, the photovoltaic inverter is connected to an input end of the box-type transformer station, and an output end of the box-type transformer station is connected to an alternating current grid.

25. The power supply system according to any one of claims 1 to 19, wherein the power conversion device is the alternating current combiner box, the power supply system further comprises the photovoltaic inverter and a box-type transformer station, the photovoltaic array is connected to the alternating current combiner box through the photovoltaic inverter, the alternating current combiner box is connected to an input end of the box-type transformer station, and an output end of the box-type transformer station is connected to an alternating current grid.

26. The power supply system according to any one of claims 1 to 19, wherein the power conversion device is the DC-to-DC converter, the power supply system further comprises a direct current bus and a DC-to-alternating current AC converter, the DC-to-DC converter is connected to an input end of the DC-to-AC converter through the direct current bus, and an output end of the DC-to-AC converter is connected to an alternating current grid or an alternating current load.

27. The power supply system according to claim 26, wherein the power supply system further comprises an energy storage module and a DC-to-DC conversion module connected to the energy storage module, and the DC-to-DC conversion module is connected to the input end of the DC-to-AC converter through the direct current bus.

28. The power supply system according to claim 26 or 27, wherein the power supply system further comprises a generator and an alternating current AC-to-DC conversion module connected to the generator, and the AC-to-DC conversion module is connected to the input end of the DC-to-AC converter through the direct current bus.

29. Apower conversion device, wherein the power conversion device comprises a power cavity, a heat dissipation cavity, a power device, a magnetic element, at least one first heat sink, and at least one second heat sink, the power cavity and the heat dissipation cavity communicate with each other to form a first air duct, the power device is disposed in the power cavity, the at least one second heat sink is disposed in the heat dissipation cavity, first heat sinks are connected to the power device, and the magnetic element is disposed in the first air duct; and
the first heat sinks are configured to dissipate heat generated by the power device when the power conversion device works, and second heat sinks are configured to dissipate heat generated by the magnetic element when the power conversion device works.

30. The power conversion device according to claim 29, wherein the power conversion device further comprises at least one condenser, and a condenser is connected to at least one of the first heat sinks and/or at least one of the second heat sinks by using a steam pipe and a liquid pipe; and
the condenser is configured to: condense first gas and/or second gas by using the steam pipe, and enable liquid generated after the condensation to flow back, through the liquid pipe, to the first heat sink and/or the second heat sink, the first gas is gas generated by the first heat sink in a heat dissipation process, and the second gas is gas generated by the second heat sink in a heat dissipation process.

31. The power conversion device according to claim 29 or 30, wherein the magnetic element is disposed in the power cavity or the heat dissipation cavity.

32. The power conversion device according to claim 29 or 30, wherein one part of the magnetic element is disposed in the power cavity, and the other part of the magnetic element is disposed in the heat dissipation cavity

33. The power conversion device according to any one of claims 29 to 32, wherein the at least one first heat sink is disposed in the power cavity.

34. The power conversion device according to any one of claims 29 to 32, wherein the power conversion device further comprises a housing, the power cavity, the heat dissipation cavity, and the at least one first heat sink are disposed in the housing, and the at least one first heat sink is disposed outside the power cavity and the heat dissipation cavity.

35. The power conversion device according to any one of claims 29 to 32, wherein at least one heat sink is embedded in a side that is of the power cavity and that faces the heat dissipation cavity.

36. The power conversion device according to any one of claims 29 to 35, wherein the power conversion device further comprises at least one first fan disposed in the heat dissipation cavity; and
the first fan is configured to push airflow, so that the heat generated by the magnetic element passes through the second heat sinks.

37. The power conversion device according to claim 36, wherein the first fan is further configured to dissipate the heat generated by the magnetic element and heat generated by the second heat sinks.

38. The power conversion device according to claim 36 or 37, wherein the heat dissipation cavity is a C-shaped cavity, the first fan is separately disposed at a first communication end and a second communication end between the C-shaped cavity and the power cavity, and the magnetic element is disposed in the power cavity.

39. The power conversion device according to claim 36 or 37, wherein the heat dissipation cavity is a C-shaped cavity, the at least one first fan is disposed at a first communication end between the C-shaped cavity and the power cavity, and the magnetic element is disposed at a second communication end between the C-shaped cavity and the power cavity.

40. The power conversion device according to any one of claims 36 to 39, wherein the power conversion device further comprises an airflow distribution component, a board, and a resistor-capacitor element disposed on the board, the airflow distribution component is connected to the first air duct, and the board and the resistor-capacitor element are disposed in the power cavity; and
the airflow distribution component is configured to distribute, through the first air duct, airflow generated by first fans to the board and the resistor-capacitor element, to dissipate heat for the board and the resistor-capacitor element.

41. The power conversion device according to claim 40, wherein the airflow distribution component is disposed in the power cavity.

42. The power conversion device according to claim 40, wherein the heat dissipation cavity is the C-shaped cavity, the airflow distribution component is disposed at one end of the C-shaped cavity, and the airflow distribution component is inserted into the power cavity.

43. The power conversion device according to any one of claims 34 to 42, wherein the power conversion device further comprises the housing, and a second fan and the at least one condenser that are disposed in the housing, and the condenser is connected to the at least one of the first heat sinks and/or the at least one of the second heat sinks by using the steam pipe and the liquid pipe; and
the second fan is disposed outside the power cavity and the heat dissipation cavity, and is configured to dissipate heat generated by condensers and heat generated by the first heat sinks.

44. The power conversion device according to claim 43, wherein the second fan is connected to the condensers through a second air duct, and is configured to dissipate, through the second air duct, the heat generated by the condensers.

45. The power conversion device according to any one of claims 29 to 44, wherein the power cavity and the heat dissipation cavity are waterproof and dustproof to form a high ingress protection cavity.

46. The power conversion device according to any one of claims 29 to 45, wherein a breather valve is disposed in the power cavity or the heat dissipation cavity.

47. A power system, wherein the power system comprises a power battery and the power conversion device connected to the power battery according to any one of claims 29 to 46.
